(19) Europäisches Patentamt
European Patent Office
Office européen des brevets

(11) **EP 3 095 754 B1**

(12) **EUROPEAN PATENT SPECIFICATION**

(45) Date of publication and mention
of the grant of the patent:
**10.10.2018 Bulletin 2018/41**

(51) Int Cl.:
**B81B 3/00** (2006.01)

(21) Application number: **16169090.4**

(22) Date of filing: **11.05.2016**

(54) **LOW PRESSURE SENSOR AND FLOW SENSOR**

NIEDERDRUCKSENSOR UND FLUSSSENSOR

CAPTEUR À BASSE PRESSION ET CAPTEUR D'ÉCOULEMENT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **22.05.2015 US 201514719848**

(43) Date of publication of application:
**23.11.2016 Bulletin 2016/47**

(73) Proprietor: **Amphenol Thermometrics, Inc.
Saint Mary's PA 15857-3397 (US)**

(72) Inventors:
• **Belov, Nickolas S.
Schenectady, NY New York 12345 (US)**

• **Li, Lihua
Schenectady, NY New York 12345 (US)**
• **Vu, Kim
Milpitas, CA 95035 (US)**
• **Vu, Dinh
Schenectady, NY New York 12345 (US)**

(74) Representative: **P&TS SA (AG, Ltd.)
Av. J.-J. Rousseau 4
P.O. Box 2848
2001 Neuchâtel (CH)**

(56) References cited:
**US-A1- 2006 272 413    US-A1- 2011 048 138
US-A1- 2011 298 705**

## Description

FIELD

The subject matter disclosed herein relates to low pressure sensors and flow sensors.

BACKGROUND

Pressure sensors can be used in a variety of applications to sense and measure pressure. In some medical, industrial, automotive, aerospace, and other applications, a pressure sensor must be highly sensitive in order to be able to sense low pressure. High sensitivity low pressure sensors can be used in some applications for flow measurements.

One type of pressure sensor that has been traditionally used for low pressure measurements is a silicon-based MEMS (MicroElectroMechanical Systems) piezoresistive pressure sensor. MEMS piezoresistive pressure sensors typically have a diaphragm and piezoresistors located on the diaphragm. When a pressure drop is applied to the diaphragm, the diaphragm bends, and resistance of the piezoresistors changes as a result of bending stress. Typically, the MEMS piezoresistive pressure sensor has four piezoresistors connected to a Wheatstone bridge circuit. Piezoresistors are located on the diaphragm in such a way that in response to an applied pressure, resistance of two of the resistors in the Wheatstone bridge circuit increases and resistance of the other two resistors in the Wheatstone bridge circuit decreases.

Pressure sensors typically require thin diaphragms in order to meet pressure sensitivity requirements when sensing low pressure. However, pressure sensors with a uniform-thickness diaphragm can have significant non-linearity because of factors such as non-linearity of transforming applied pressure to mechanical stress (e.g., non-linearity of the uniform-thickness diaphragm), non-linearity of transforming mechanical stress into change of resistance (e.g., non-linearity of the piezoresistive effect), and non-linearity of transforming change of resistance into output signal (e.g., non-linearity of the Wheatstone bridge circuit). Although multiple factors can influence non-linearity, non-linearity of transforming applied pressure to mechanical stress is typically the dominant factor for low-pressure sensors. An output signal S of a piezoresistive pressure sensor with a uniform-thickness diaphragm is directly proportional to applied pressure P and directly proportional to a squared ratio of diaphragm linear dimension A to diaphragm thickness d:

$$S \sim P \cdot (A/d)^2 \quad \text{or} \quad S \sim 1/d^2$$

Low pressure sensors require high sensitivity, namely a high output signal at small values of pressure. Therefore, a high (A/d) ratio is required. In many cases it is desirable to decrease diaphragm thickness d because an increase of linear dimension of the diaphragm leads to die size increase and die cost increase. The minimum diaphragm thickness is typically determined by process capabilities.

The transformation of pressure to stress remains linear only when diaphragm deflection $Z_{max}$ is much smaller than the diaphragm thickness d. For a given pressure, the maximum diaphragm deflection is proportional to the fourth power of diaphragm linear dimension A and inversely proportional to the cube of diaphragm thickness:

$$Z_{max} = A^4/d^3 \quad \text{or} \quad Z_{max} \sim 1/d^3$$

For small diaphragm deflections, the nonlinearity NL of a uniform diaphragm can be considered proportional to ($Z_{max}$/d) ratio, making non-linearity a very strong function of linear dimension A to diaphragm thickness d ratio:

$$NL = (A/d)^4 \quad \text{or} \quad NL \sim 1/d^4$$

If the (A/d) ratio increases, then non-linearity of pressure sensors increases much faster, as $(A/d)^4$, than sensitivity, which increases as $(A/d)^2$. As a result, large pressure measurement error due to non-linearity of transduction characteristic makes low-pressure sensor designs with uniform-thickness diaphragms non-practical.

A solution for improving pressure sensor linearity while keeping high sensitivity required for low pressure applications has been known since the late 1970s. It has been demonstrated that forming rigid islands (or bosses) on thin diaphragms can decrease non-linearity of low pressure sensors.

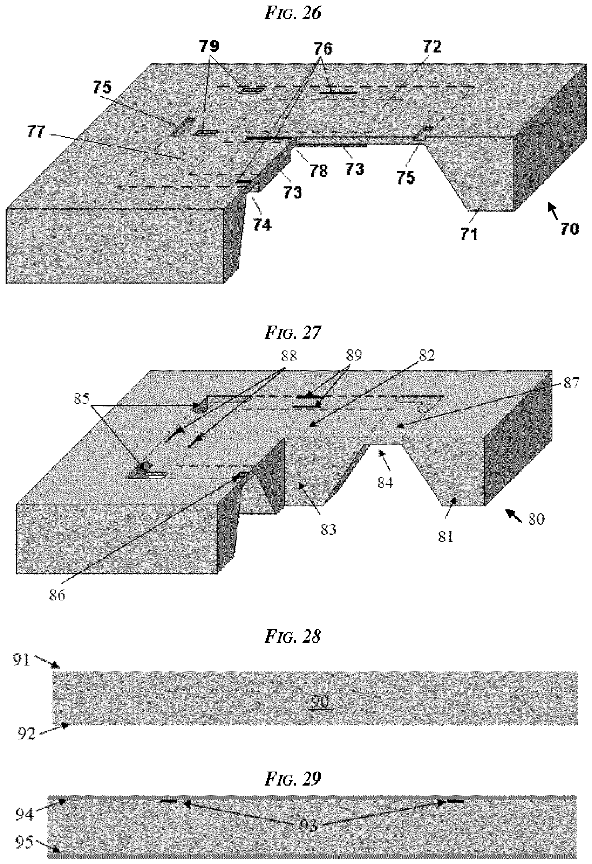

A majority of pressure sensors are manufactured on silicon wafers having (100) orientation. Rigid islands are typically formed by wafer micromachining using wet anisotropic etching. This process results in forming structures with side walls defined by (111) planes. Side walls of the rigid islands are also defined by the (111) planes. The (111) planes have very low etching rate in etchants used for micromachining, and it is beneficial for defining a reproducible microstructure geometry, e.g. size and shape of the cavity, bosses and diaphragm. An example of a microstructure having a rigid island can be found in FIG. 27. Select aspects of FIG. 27 are discussed in this Background section for clarity of description. The totality of FIG. 27 is discussed below as being illustrative of an embodiment of a sensor die disclosed herein.

The sensor die 80 shown in FIG. 27 has a frame 81 and a cavity with one rigid island 83 formed by wafer micromachining from the back side. The rigid island 83 defines narrow diaphragm areas 84 between the rigid island 83 and the frame 81. Such narrow diaphragm areas are often referred as grooves, and their width is referred to as width of the grooves. Overall design of the pressure sensor die with one or more bosses is often referred as a design with a diaphragm having non-uniform thickness or a non-uniform diaphragm. The generic term "elastic element" is also used to describe a diaphragm having non-uniform thickness due to rigid islands and/or openings. The same terminology is used herein.

When a pressure drop is applied to a pressure sensor die that has diaphragm with bosses, then only narrow diaphragm areas (for example, the areas 84 in FIG. 27) can bend and bosses do not bend as they are very thick. Narrow diaphragm areas work as stress concentrators, and piezoresistors 88, 89 placed in these areas have high sensitivity. At the same time, non-linearity of the transduction characteristic can be proportional not to the fourth power of linear dimension of the diaphragm, but to the fourth power of the groove width. Therefore, non-linearity of a pressure sensor with a diaphragm having non-uniform thickness can be much lower than that of a sensor with a uniform-thickness diaphragm.

There are other designs of pressure sensor chips with non-uniform diaphragms known in the art, including designs with two bosses located in the center of the diaphragm.

One problem with traditional pressure sensors having a cavity, a thin diaphragm, and boss(es) is that the microstructure occupies a large area on the sensor die because side walls of both the cavity and the boss(es) have a slope relative to top and bottom surfaces of the wafer and top and bottom surfaces of the diaphragm. The (111) planes form an angle of atan(sqrt(2)/2) $\approx$ 35°16' with the top and bottom surfaces of the diaphragm. Therefore, if a cavity depth of the wafer is equal to D, then width of a single slope is equal to D/sqrt(2). Thus, a sensor die with two bosses has six slopes with a total width of the slopes equal to 6D/sqrt(2), and a sensor die with one boss has four slopes with a total width of the slopes equal to 4D/sqrt(2). For example, if wafer thickness is 400 $\mu$m and diaphragm thickness is 10 $\mu$m, then cavity depth is 390 $\mu$m and a total width of the slopes on a die having a diaphragm with two bosses is $\approx$ 1655 $\mu$m. The slopes require a certain minimum size of the microstructure and the sensor die, which can increase cost since larger dies are more expensive, and which can require that the sensor die have a size or cost larger than desired for certain applications and/or allow for fewer components in a system including the sensor die that occupies a certain minimum amount of real estate. Additionally, the limitations on die size can be magnified with increased wafer thickness. For example, moving from 100 mm to 150 mm or 200 mm wafers can require proportional increase of wafer thickness and proportional increase of pressure sensor die size.

Another problem with traditional pressure sensors having a cavity, a thin diaphragm, and boss(es) is that mechanical damage of the thin diaphragm(s), including diaphragm breakage, can occur in manufacturing the sensor. If a sensor die is designed to respond to very low pressure, then the thin diaphragm has low bending stiffness, and a small pressure or force applied to the diaphragm can result in high stress in the diaphragm and can cause the diaphragm to break. For example, water flow at sawing, a vacuum applied to one side of a diaphragm in wafer / die handling, and other similar situations in manufacturing can cause mechanical damage of the diaphragm. It can therefore be difficult to manufacture low pressure sensors having adequately low sensitivity without causing diaphragm breakage due to low mechanical strength of diaphragm.

Accordingly, there remains a need for improved low pressure sensors and flow sensors.

US2011/298705 discloses a device for sensing a physical parameter according to the introductory portion of claim 1. US2006/272413 and US2011/048138 disclose also devices for sensing a physical parameter.

BRIEF DESCRIPTION

In order to overcome these and other drawbacks in the related art, a low pressure sensor is provided, including a sensor die and a stress-sensitive circuit. The sensor die includes a cavity and a rigid island within the cavity. The cavity includes a peripheral groove surrounding the rigid island. The cavity creates an elastic element of the sensor die and the peripheral groove creates a thin area of the elastic element. The stress-sensitive circuit includes a stress-sensitive component in the thin area of the elastic element and outputs a signal proportional to a physical parameter. A recess or a through hole formed in the thin area of the elastic element increases the elasticity of the elastic element and the sensitivity of the sensor.

In another embodiment a low pressure sensor die also has a cap for protection of the elastic element from both overload and direct contact with mechanical objects during pressure sensor manufacturing. A cap bonding area does not overlap with the elastic element. There is a gap between the elastic element and a surface of the cap that faces the elastic element and there is at least one stop area within the gap. The device is configured such that: in response to the measured parameter that is less than a threshold, the elastic element deflects without making contact with the at least one stop area; in response to the measured parameter that is greater than the threshold, the elastic element deflects and makes contact with the at least one stop area and the cap provides additional support to increase a maximum value of the physical parameter the elastic element can withstand without damage.

A method of manufacturing a low pressure sensor is also provided, including providing a sensor die, fabricating a stress-sensitive integrated circuit, micromachining a cavity in the senor die such that the cavity includes a rigid island and a peripheral groove surrounding the rigid island, and etching a recess in the sensor die. The cavity creates an elastic element of the sensor die and the peripheral groove creates a thin area of the elastic element. The stress-sensitive circuit includes a stress-sensitive component in the thin area of the elastic element and outputs a signal proportional to a physical parameter. The recess is etched in the thin area of the elastic element, which increases the elasticity of the elastic element and the sensitivity of the sensor.

BRIEF DESCRIPTION OF THE DRAWING

These and other features will be more readily understood from the following detailed description taken in conjunction with the accompanying drawings, in which:

FIG. 1 is a perspective, partial cross sectional view of one embodiment of a sensor die configured to sense low pressure;

FIG. 2 is a side cross-sectional view of one embodiment of a silicon on insulator wafer;

FIG. 3 is a side cross-sectional view of the wafer of FIG. 2 having dielectric layers on front and back sides thereof and including stress-sensitive components on the front side;

FIG. 4 is a side cross-sectional view of the wafer of FIG. 3 having a layer deposited on the back side of the wafer;

FIG. 5 is a side cross-sectional view of the wafer of FIG. 4 having a cavity pattern etched into the back side of the wafer through the deposited layer and the bottom side dielectric layer;

FIG. 6 is a side cross-sectional view of the wafer of FIG. 5 having a photoresist covering a frame of the wafer and an area inside the cavity pattern;

FIG. 7 is a side cross-sectional view of the wafer of FIG. 6 having a trench etched in the back side of the wafer;

FIG. 8 is a side cross-sectional view of the wafer of FIG. 7 with the photoresist removed therefrom;

FIG. 9 is a side cross-sectional view of the wafer of FIG. 8 having a cavity formed in the back side of the wafer that defines a central boss;

FIG. 10 is a side cross-sectional view of the wafer of FIG. 9 having a portion of a buried oxide layer of the wafer etched away;

FIG. 11 is a perspective, partial cross sectional view of another embodiment of a sensor die configured to sense low pressure;

FIG. 12 is a side cross-sectional view of one embodiment of a non-silicon on insulator wafer;

FIG. 13 is a side cross-sectional view of the wafer of FIG. 12 having areas of diffused impurity therein;

FIG. 14 is a side cross-sectional view of the wafer of FIG. 13 having a layer on a top side of the wafer;

FIG. 15 is a side cross-sectional view of the wafer of FIG. 14 having dielectric layers on front and back sides thereof and including stress-sensitive components on the front side;

FIG. 16 is a side cross-sectional view of the wafer of FIG. 15 having an opening formed in the back side thereof through the back side dielectric layer;

FIG. 17 is a side cross-sectional view of the wafer of FIG. 16 having a cavity formed in the wafer through the opening;

FIG. 18 is a side cross-sectional view of another embodiment of a non-silicon on insulator wafer;

FIG. 19 is a side cross-sectional view of the wafer of FIG. 18 having areas of diffused impurity therein;

FIG. 20 is a side cross-sectional view of the wafer of FIG. 19 having a layer on a top side of the wafer;

FIG. 21 is a side cross-sectional view of the wafer of FIG. 20 having dielectric layers on front and back sides thereof and including stress-sensitive components on the front side;

FIG. 22 is a side cross-sectional view of the wafer of FIG. 21 having an opening formed in the back side thereof through the back side dielectric layer;

FIG. 23 is a side cross-sectional view of the wafer of FIG. 22 having a portion of a cavity formed in the wafer through the opening;

FIG. 24 is a side cross-sectional view of the wafer of FIG. 23 having another portion of the cavity formed in the wafer;

FIG. 25 is a side cross-sectional view of the wafer of FIG. 24;

FIG. 26 is a side cross-sectional view of one embodiment of a sensor die configured to sense low pressure and that includes stress concentrators in the form of recesses;

FIG. 27 is a side cross-sectional view of one embodiment of a sensor die configured to sense low pressure and that includes stress concentrators in the form of holes;

FIG. 28 is a side cross-sectional view of another embodiment of a wafer;

FIG. 29 is a side cross-sectional view of the wafer of FIG. 28 having dielectric layers on front and back sides thereof and including stress-sensitive components on the front side;

FIG. 30 is a side cross-sectional view of the wafer of FIG. 29 including a lithography defining pattern on the back side of the wafer;

FIG. 31 is a side cross-sectional view of the wafer of FIG. 30 having a cavity formed therein through the lithography defining pattern;

FIG. 32 is a side cross-sectional view of the wafer of FIG. 31 having stress concentrators in the form of holes formed in the top side of the wafer;

FIG. 33 is a side cross-sectional view of one embodiment of a sensor die configured to sense low pressure and that includes a cap;

FIG. 34 is a side cross-sectional view of another embodiment of a wafer;

FIG. 35 is a side cross-sectional view of the wafer of FIG. 34 having patterns formed on front and back sides thereof;

FIG. 36 is a side cross-sectional view of the wafer of FIG. 35 having holes formed in the wafer using the front side pattern and having dicing grooves formed in the wafer using the back side pattern;

FIG. 37 is a side cross-sectional view of one embodiment of a device wafer layer that includes stress concentrators in the form of holes;

FIG. 38 is a side cross-sectional view of the wafer of FIG. 36 bonded as a cap to the device wafer layer of FIG. 37;

FIG. 39 is a side cross-sectional view of the cap of FIG. 38 having a first tape on the front side thereof and the device wafer layer having a second tape on a bottom side thereof;

FIG. 40 is a side cross-sectional view of the cap of FIG. 39 having side portions cut away therefrom;

FIG. 41 is a side cross-sectional view of the wafer of FIG. 40 having the first and second tapes removed therefrom;

FIG. 42 is a side cross-sectional view of one embodiment of a sensor die configured to sense low pressure and including a cap wafer layer bonded to a device wafer layer, the sensor die including stop elements positioned in a gap between the cap and device wafer layers;

FIG. 43 is a side cross-sectional view of another embodiment of a sensor die configured to sense low pressure and including a cap wafer layer bonded to a device wafer layer, the sensor die including stop elements positioned in a gap between the cap and device wafer layers;

FIG. 44 is a side cross-sectional view of another embodiment of a sensor die configured to sense low pressure and including a cap wafer layer bonded to a device wafer layer;

FIG. 45 is a side cross-sectional view of another embodiment of a sensor die configured to sense low pressure and including a cap wafer layer bonded to a device wafer layer, the sensor die including stop elements positioned in a gap between the cap and device wafer layers;

FIG. 46 is a graph showing deflection versus applied pressure for an embodiment of a sensor die configured to sense low pressure; and

FIG. 47 is a graph showing maximum von-Mises stress versus applied pressure for the sensor die of FIG. 46.

DETAILED DESCRIPTION

Certain exemplary embodiments will now be described to provide an overall understanding of the principles of the structure, function, manufacture, and use of the devices, systems, and methods disclosed herein. One or more examples of these embodiments are illustrated in the accompanying drawings. Those skilled in the art will understand that the devices, systems, and methods specifically described herein and illustrated in the accompanying drawings are non-limiting exemplary embodiments and that the scope of the present invention is defined solely by the claims. The features illustrated or described in connection with one exemplary embodiment may be combined with the features of other embodiments. Such modifications and variations are intended to be included within the scope of the present invention.

Various exemplary low pressure sensors and flow sensors are provided. In general, the low pressure sensors and flow sensors can be configured to sense pressure of an external media, e.g., a fluid.

The devices, systems, and methods disclosed herein produce a number of advantages and/or technical effects.

In some embodiments, a pressure sensor can include a Silicon-On-Insulator (SOI) die that includes a handle layer, a device layer, a dielectric layer disposed between the handle and device layers, and a cavity that is formed in a bottom side of the handle layer. The cavity defines a thin diaphragm area and at least one rigid island that includes a portion of the handle layer. The at least one rigid island can be surrounded by the thin diaphragm area. A maximum thickness of the at least one rigid island can be substantially smaller than a thickness of the SOI die and can be greater than a thickness of the thin diaphragm area. The thin diaphragm area and the at least one rigid island can define an elastic element that is surrounded by a frame that includes a portion of the handle layer. The die can have top and bottom surfaces that are parallel to one another. The side walls of the cavity and the side walls of the at least one rigid island can be substantially vertical. The top and bottom surfaces of the substrate may not be exactly parallel to one another but still be considered to be substantially parallel because of, for example, roughness of surfaces, tolerances allowed in manufacturing, etc. Similarly, the side walls of the rigid island(s) and the cavity may not be exactly perpendicular to the top and bottom surfaces of the die but still be considered to be substantially perpendicular thereto because of, for example, tolerances allowed in manufacturing. For example, the side wall of the cavity that is perpendicular to the top and bottom surfaces of the die may make an angle in a range from 85° to 95° with both the top and bottom surfaces of the die, and the side wall of the rigid island that is perpendicular to the top and bottom surfaces of the die may make an angle in a range from 85° to 95° with both the top and bottom surfaces of the die. As discussed further below, such side walls of the cavity and the at least one rigid island can be formed by dry etching the cavity into the die with the dielectric layer acting as an etch stop that stops the dry etching from etching the device layer. The side walls of the cavity and the at least one rigid island can allow a size of the die to be significantly reduced as compared to dies having a cavity and one or more rigid islands having sloped side walls. Correspondingly, more dies can be placed on one wafer, and for a similar cost of wafer processing, die cost can be reduced.

For example, a sensor die formed using dry etching of silicon and having a 1.00 mm x 1.00 mm x 0.010 mm thin diaphragm area and a 0.85 mm x 0.85 mm boss, needs to have 0.50 mm wide frame and wafer having 0.50 mm thickness. Thus, a size of the die will be 2.0 mm x 2.0 mm, and die area on the wafer will be equal to 4.0 mm$^2$. Conversely, a sensor die having a 1.00 mm x 1.00 mm x 0.010 mm thin diaphragm area and a 0.85 mm x 0.85 mm boss and formed using wet anisotropic etching will have a wider cavity due to boss slope of 0.35 mm. Die size would thus be 2.70 mm x 2.70 mm, and die area would be 7.29 mm$^2$, which is more than 80% greater than area of the die formed using dry etching of silicon.

A thickness of the thin diaphragm area can be substantially smaller than a total thickness of the handle, dielectric, and device layers, which can help provide high sensitivity of the sensor to applied pressure.

The substantially parallel side walls of the cavity and the at least one rigid island can allow narrow grooves, also referred to herein as trenches, to be defined between the side walls of the at least one rigid island and the side walls of the cavity. A width of the narrow grooves can be substantially smaller than the linear dimensions of the diaphragm, which can allow for high linearity of the sensor's transduction characteristic.

By having the substantially vertical side walls of the at least one rigid island and having a thickness of the at least one rigid island being substantially smaller than a total thickness of SOI substrate, the sensor die can have small sensor error in response to acceleration or to position of the sensor die due to gravity. A person skilled in the art will appreciate that inertial forces due to mass of the rigid island(s) and due to acceleration caused by sensor motion (e.g., if the pressure sensor is a part of a wearable medical device or if the pressure sensor is installed on a vibrating object) can cause mechanical stresses in the diaphragm and that these stresses will be proportional to the mass of the rigid island(s). These stresses can result in a parasitic signal, as they are not related to measured pressure. The rigid island(s) having substantially vertical side walls and having the maximum thickness substantially smaller than the total thickness of SOI substrate can have a mass less than a rigid island having sloped side walls that are not substantially vertical and having the same thickness as the SOI substrate, thereby providing for less pressure measurement error caused by acceleration and gravity.

In some embodiments, a pressure sensor can include a sensor die that includes a semiconductor substrate and a cavity that is formed in a bottom side of the substrate and that defines an elastic element including a thin diaphragm area of the substrate and at least one rigid island of the substrate. The die can have top and bottom surfaces that are parallel to one another. Side walls of the at least one rigid island can substantially perpendicular to the top and bottom surfaces of the die so as to be substantially vertical. Similar to that discussed above, the substantially vertical side walls of the at least one rigid island can allow a size of the die to be significantly reduced as compared to dies having one or more rigid islands having sloped side walls, and more dies can be placed on a wafer. As discussed further below, such side walls of the at least one rigid island can be formed by wet etching the cavity into the die. Using wet etching can allow wafers to be batch processed, as opposed to individual etching of one wafer at a time in the case of dry etching of the cavity.

The wafer can have an impurity diffused in one or more portions thereof prior to the wet etching such that the one or more portions are doped. The doping of the wafer can allow the diffused one or more portions to define the at least one rigid island when the wafer is wet etched. The doped portion(s) of the wafer will etch at a different rate than a remaining, non-doped portion of the wafer, thereby allowing the at least one rigid island to be formed.

The wafer can be etched using deep reactive-ion etching (DRIE) in addition to wet etching. DRIE and/or wet etching can be used to reduce a size of the die, as discussed further below.

In some embodiments, a pressure sensor can include a substrate and a cavity that is formed in a bottom side of the substrate and that defines a diaphragm including a thin diaphragm area and at least one rigid island formed within the substrate. The diaphragm can have a plurality of stress concentrators formed therein, e.g., in the thin diaphragm area, which can reduce stiffness of the diaphragm. As a result, a small pressure drop on the diaphragm can create large stress in the diaphragm that can be detected by one or more stress-sensitive components, e.g., piezoresistors, coupled to the diaphragm. The plurality of stress concentrators can thus allow an increase in sensitivity of the sensor. The plurality of stress concentrators can have a variety of forms, such as recesses formed in a surface of the diaphragm or holes extending through a surface of the diaphragm.

In some embodiments, a pressure sensor can include a sensor die that includes an elastic element, and the sensor can include a cap bonded to a top surface of the sensor die. The sensor can also include one or more stops formed on the top surface of a sensor die and/or on a bottom surface of the cap. A gap can exist between the bottom surface of the cap and the top surface of the sensor die. When the diaphragm is deflected in response to mechanical stress, e.g., to pressure of a fluid passing by the sensor, the stop(s) can be configured to limit the maximum deflection of the elastic element while preventing the top surface of the elastic element from directly contacting the bottom surface of the cap over a substantial area of the cap's bottom surface, which can result in stiction between the two surfaces. In this way, the diaphragm can be protected from breakage by excessive pressure applied to the elastic element and from failure related to stiction between the elastic element and the cap.

The sensors disclosed herein can be used in a variety of applications, such as medical applications (e.g., in respiratory treatment), industrial applications, automotive applications, and aerospace applications. For example, medical applications can include applications in which one or more parameters such as pressure, breathe rate, pulse, etc. associated with a patient are measured, and industrial applications can include manufacturing applications in which one or more parameters such as temperature, pressure, etc. is sensed.

The sensors disclosed herein can include one or more other types of sensing functionality. For example, a sensor can include any one or more of a pressure sensor, a temperature sensor, an accelerometer, a magnetic sensor, and a chemical sensor. The sensor can thus be more versatile when in use by being configured to provide data regarding a plurality of different parameters and/or can allow one sensor to be used instead of multiple sensors, which can help reduce monetary cost and/or can help conserve real estate that can be left open or used for other devices.

In some embodiments, the low pressure sensors disclosed herein can be used to measure flow. As will be appreciated by a person skilled in the art, flow can be measured using an indirect method when a pressure drop created by flow of a fluid is measured and corresponding flow is calculated based on the pressure measurements. As will also be appreciated by a person skilled in the art, flow sensors often do not require separation of media by a solid non-permissible for the measured fluid diaphragm.

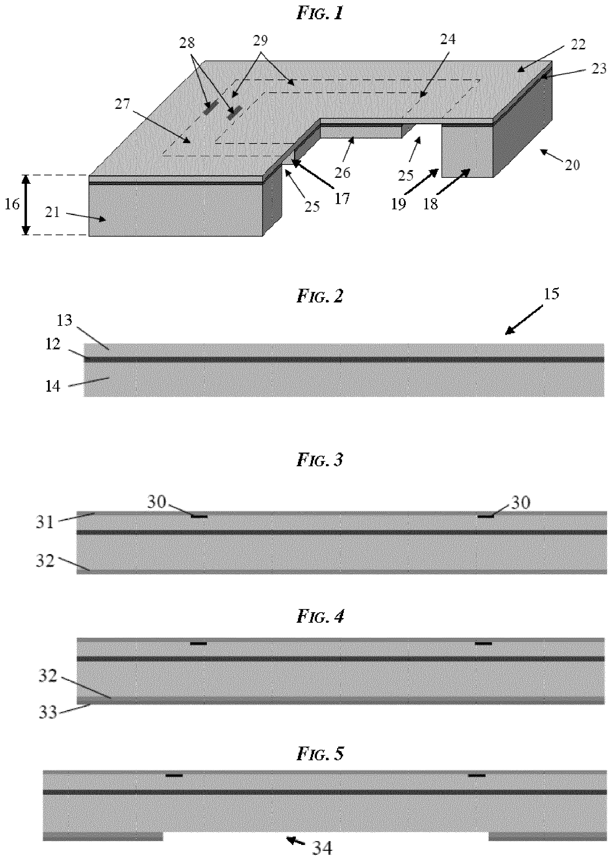

FIG. 1 illustrates an embodiment of a pressure sensor die 20 configured for low pressure sensing. The die 20 can be fabricated from a SOI substrate. The substrate includes a handle layer 21, a device layer 22, and a dielectric layer 23 sandwiched between the handle layer 21 and the device layer 22. The dielectric layer 23 can be a buried oxide (BOX) such as silicon dioxide. A total thickness 16 of the substrate can be defined by a sum of a thickness of the handle layer 21, a thickness of the device layer 22, and a thickness of the dielectric layer 23. The thickness 16 of the substrate can be, e.g., in a range of 100 $\mu$m to 1000 $\mu$m.

The die 20 can have a cavity 25 formed therein. The cavity 25 can be formed in a bottom portion of the substrate and can extend at least through the thickness of the handle layer 21. In this illustrated embodiment, the cavity 25 extends through the thickness of the handle layer 21 and the thickness of the dielectric layer 23 but does not extend into the device layer 22. The cavity 25 can be formed, and hence a diaphragm 24 can be defined, using dry etching of silicon, as discussed further below.

The cavity 25 can be surrounded by a frame 18, which is a portion of the substrate. The frame 18 can include portions of each of the handle, device, and dielectric layers 21, 22, 23. An outer perimeter of the frame 18 can define an outer perimeter of the die 20, and an inner perimeter of the frame 18 can define an outer perimeter of the cavity 25 and an outer perimeter of the diaphragm 24. The diaphragm 24 has a rectangular outer perimeter in this illustrated embodiment, but the diaphragm's outer perimeter in this and other embodiments discussed herein can have different shapes, e.g., square, polygon, square with rounded corners, rectangle with rounded corners, polygon with rounded corners, circle, oval, etc.

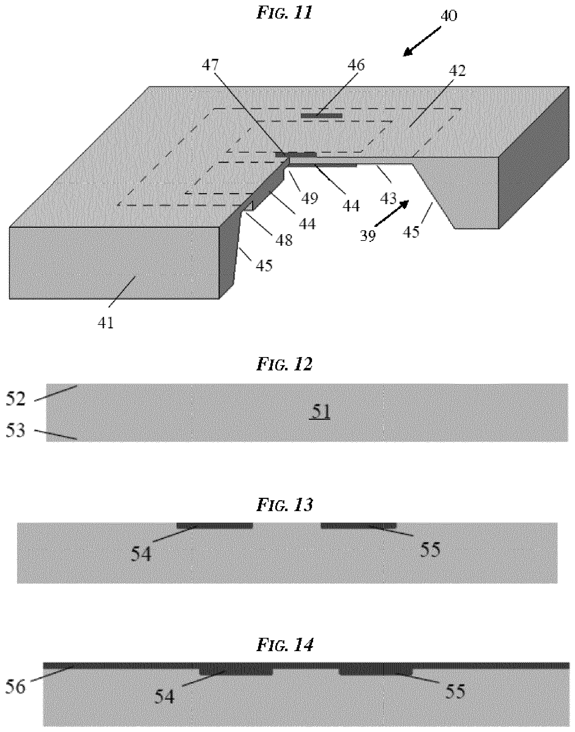

The diaphragm 24, also referred to herein as an elastic element, can include a rigid island 26, also referred to herein as a boss, and a thin area 27, also referred to herein as a thin diaphragm area. The thin area 27 can be located above the cavity 25. The thin area 27 can be a flexible member configured to bend in response to an external stimulus, e.g., in response to pressure exerted thereon. The diaphragm 24 can thus bend so as to move in and out of the cavity 25. The rigid island 26 can be completely surrounded by the thin area 27. Although the die 20 includes a single rigid island 26 in this illustrated embodiment, a die can include a plurality of rigid islands. A die with two bosses can be similar to the structure shown in FIG. 11, discussed further below, where the bosses 44 define two side grooves 48 located between each of the two bosses 44 and a frame 41, and one central groove 49 located between the bosses 44. Longitudinal axes of all the grooves 48, 49 can be parallel to each other. Geometry of the two bosses 44 can be symmetric with respect to a central axis of the die. A length of the central groove 49 can be different than length of the side grooves 48.

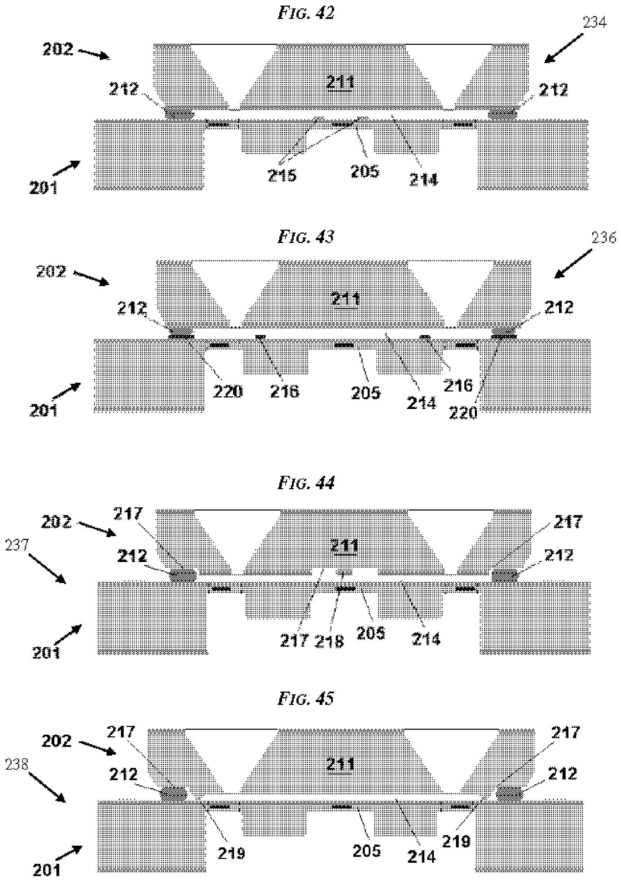

A side wall 17 of the rigid island 26 can be parallel to a side wall 19 of the cavity 25 that faces the side wall 17 of the rigid island 26. The side walls 17, 19 are each perpendicular to top and bottom surfaces of the diaphragm's thin area 27 and to top and bottom surfaces of the substrate, e.g., to a top surface of the device layer 22 and to a bottom surface of the handle layer 21, that are parallel to one another. As mentioned above, the side walls 17, 19 may not be exactly parallel to one another and/or top and bottom surfaces of the substrate may not be exactly parallel to one another but still be considered to be substantially parallel because of, for example, tolerances allowed in manufacturing, and the side walls 17, 19 may not be exactly perpendicular to the top and bottom surfaces of the substrate but still be considered to be substantially perpendicular because of, for example, tolerances allowed in manufacturing. For example, the side wall 19 of the cavity 25 that is perpendicular to the top and bottom surfaces of the substrate may make an angle in a range from 85° to 95° with both the top and bottom surfaces of the substrate. The side walls 17, 19 define a groove between the rigid island 26 and the frame 18. When the side walls 17, 19 are substantially parallel to each other, then the groove can have a rectangular shape. However, shape of the groove can be different e.g., the side walls 17, 19 can be not substantially parallel to each other forming a reentrant profile at the ends of the groove. In an embodiment that includes plurality of bosses, each of the bosses can have a side wall that faces either a side wall of the cavity or a side wall of another one of the bosses. Each of the plurality of boss' side walls will be perpendicular to top and bottom surfaces of the diaphragm's thin area and to top and bottom surfaces of the substrate. Examples of sensor dies having multiple bosses are illustrated in FIGS. 42-45, which are discussed further below. FIGS. 42-45 show embodiments of sensor dies that include an elastic element with a rectangular perimeter shape and having two rectangular bosses located symmetrically with respect to a longitudinal axis of symmetry of the rectangular shape of the elastic element, or that have an elastic element having a polygonal perimeter shape with at least one axis of symmetry with two rectangular rigid islands located symmetrically with respect to the at least one axis of symmetry.

The thin area 27 can have one or more narrow grooves 29 defined between the rigid island 26 and the side wall 19 of the cavity 25. A width of the one or more narrow grooves 29 can be significantly less than linear dimensions of the diaphragm 24.

The elastic element 24 can include portions of each of the handle, device, and dielectric layers 21, 22, 23. The thin diaphragm area 27 can include only a portion of the device layer 22, as in the illustrated embodiment, although the thin diaphragm area 27 can include at least a portion of the dielectric layer 23 and at least a portion of the handle layer 21. The boss 26 can include portions of each of the handle, device, and dielectric layers 21, 22, 23.

A thickness of the thin area 27 can equal the thickness of the device layer 22. The thin area's thickness can be sufficiently small that the thin area 27 can bend or flex in response to a mechanical load, e.g., an applied pressure. As will be appreciated by a person skilled in the art, the thickness of the thin area 27 can depend on the diaphragm's size, required die sensitivity, and target measurement range, e.g., target range of pressure measurements. The thickness of the thin area 27 can be substantially less than the total thickness 16 of the substrate. The thickness of the thin area 27 can be, e.g., in a range of 1 to 20 $\mu$m.

The rigid island's thickness can be sufficiently great that the rigid island 26 can be much stiffer than the thin area 27 so as to not bend or flex in response to a mechanical load, e.g., an applied pressure. The thickness of the boss 26 can be greater than the thickness of the thin area 27, less than the total thickness of the substrate, greater than the thickness of the device layer 22, greater than the thickness of the dielectric layer 23, and less than the thickness of the handle layer 21. In an exemplary embodiment, the thickness of the boss 26 can be significantly less than the thickness of the substrate, e.g., at least 10 $\mu$m less than the thickness 16 of the substrate that is in a range of 100 to 1000 $\mu$m. A small thickness of the boss 26 relative to total thickness of the substrate can allow for better reproducibility of the geometry of the groove 29 and to minimize parasitic error caused by gravity and acceleration. The thickness of the rigid island 26 can be at least 1.5 times greater than the thickness of the thin area 27, e.g., 2.0 times greater than the thickness of the thin area 27, in a range of about 1.5 to 3.0 times greater than the thickness of the thin area 27, which can help provide improved linearity of the transduction characteristic. If boss height is equal to diaphragm thickness in the thin area 27, then the boss 26 is two times thicker than the thin area 27 and bending stiffness of the portion of elastic element 24 occupied by the boss 26 is eight times of that of a portion of uniform-thickness diaphragm having the same footprint as the boss 26. Such increase in stiffness can be sufficient to result in much bigger bending curvature and stress concentration in the groove 29. If boss height is two times bigger than the diaphragm thickness in the thin area 27, then bending stiffness of the boss 26 is twenty-seven times of that of a uniform-thickness diaphragm and bending of the boss 26 can be negligible in comparison with bending of the thin area 27.

The die 20 can also include one or more stress sensitive components 28. The one or more stress sensitive components 28 can be formed in the device layer 22 within the thin area 27 of the diaphragm 24. Each of the one or more narrow grooves 29 can seat one of the one or more stress sensitive components 28. Mechanical load, e.g., pressure, vibration, etc., applied to the diaphragm 24 can cause the thin portion 27 of the diaphragm 24 to bend, and hence cause the one or more stress sensitive components 28 to sense the stress. The die 20 in the illustrated embodiment includes four pressure sensitive components 28 (two are in the unillustrated cut away portion of the die 20), but a pressure sensor chip can include any number of stress sensitive components. The stress sensitive components 28 may include one or more of stress-sensitive resistors or piezoresistors, p-n-p bipolar transistors, n-p-n bipolar transistors, p-channel metal oxide semiconductor (MOS) transistors n-channel MOS transistors, complementary metal oxide semiconductor (CMOS) transistor pairs, unipolar transistors, diodes, and/or other electrical components, as will be appreciated by a person skilled in the art.

The one or more stress-sensitive components 28 can be used in different electrical circuits. For example, piezoresistors can be combined in a Wheatstone bridge circuit. In some cases, only some resistors in the stress-sensitive circuit can be stress sensitive. For another example, stress-sensitive transistors can be used to form differential amplifiers and operational amplifiers, switching circuits, pulse generators (ring oscillator and others), voltage-to-frequency converters, and other circuits. Stress-sensitive circuits can include both piezoresistors and transistors. For example, a piezoresistor can be connected to at least one bipolar transistor or at least one MOS transistor. Besides transforming mechanical stress in the elastic element to electrical signal, which can be done by piezoresistors or stress-sensitive transistors, a stress-sensitive circuit can provide other functions, such as providing an analog differential output signal proportional to the measured parameter, providing an analog output signal measured with respect to a ground or other reference potential and proportional to the measured parameter, analog amplification, analog-to-digital conversion, analog-to-frequency conversion, pulse generation, analog multiplexing, signal processing, memory, digital interface, power management, transmitting and receiving radio-signals, and energy harvesting.

As will be appreciated by a person skilled in the art, the stress sensitive components 28 can be connected to a stress sensitive integrated circuit configured to output a signal proportional to a value of a measured physical parameter acting on the die 20 and causing mechanical stress on the diaphragm 24, e.g., on the thin area 27. The stress sensitive components 28 being located in the one or more narrow grooves 29 can allow the components 28 to have highly linear characteristic of transforming applied load, e.g., applied pressure, to change of their parameters, for example resistance. As a result, the low pressure sensor has both high sensitivity to pressure and very small nonlinearity of its transduction characteristic. A size and profile of the boss 26, its mutual position with respect to the frame 18, the thickness of the thin area 27 of the elastic element 24, and position and orientation of the stress-sensitive components 28 within the elastic element 24 can be chosen to ensure that the sensor die 20 has a sensitivity required for a particular application and to ensure that the die's output changes linearly with applied stress, e.g., applied pressure.

A sensor die having the rigid island side walls and the cavity side walls substantially perpendicular to top and bottom surfaces of a diaphragm's thin area and to top and bottom surfaces of the die's substrate, can be formed using a fabrication process that includes dry etching of the substrate. FIGS. 2-10 illustrate one embodiment of such a fabrication process. FIGS. 2-10 show formation of a die that includes a single central boss having a rectangular shape, but other dies having a different number and/or different shape of bosses can be fabricated in a similar way. For example, bosses in this and other embodiments discussed herein can have a square shape, a rectangular shape, a polygonal shape, a polygonal shape with rounded corners, a circular shape, and an oval shape.

FIG. 2 shows a SOI wafer 15 in an initial state. The wafer 15 includes a handle layer 14, a device layer 13, and a dielectric layer 12 sandwiched therebetween. The wafer 15 can undergo processing to form stress-sensitive components 30, as will be appreciated by a person skilled in the art. The stress-sensitive components 30 can be formed within the device layer 13, as shown in FIG. 3. The wafer 15 can include contacts (not shown) to the stress-sensitive components 30 connected to metal pads (not shown) for external electrical connections to the sensor chip, as will be appreciated by a person skilled in the art.

As a result of the processing, as also shown in FIG. 3, the wafer 15 can have a first dielectric layer 31 on a top or front side thereof and a second dielectric layer 32 on a bottom or back side thereof. The first and second dielectric layers 31, 32 can be the same, or the first and second dielectric layers 31, 32 can have different thicknesses and/or different compositions. The thicknesses and compositions of the first and second dielectric layers 31, 32 are determined by the wafer processing, as will be appreciated by a person skilled in the art. The second dielectric layer 32 is optional such that the back side of the wafer 15 may not have a dielectric layer at the end of the wafer process.

Next, as shown in FIG. 4, a layer 33 can be deposited on the back side of the wafer 15. The deposited layer 33 can provide an adequate protection of the back side of the wafer 15 during subsequent deep reactive ion etching (DRIE). A thickness of the additional layer 33 can be chosen depending on the thickness and composition of the second dielectric layer 32 remaining on the back side of the wafer 15, required DRIE etch depth, and etch rate selectivity of the deposited layer 33 to silicon. If the second dielectric layer 32 will provide sufficient protection of the back side during DRIE, then the deposited layer 33 can be omitted. The deposited layer 33 can be made from photoresist, dielectric, metal, polymer or other material that can provide protection of a pattern on the back side of the wafer during DRIE. If contamination of DRIE equipment by materials deposited on the front side of the wafer 15 is a concern, then the front side of the wafer 15 can be protected by a temporary layer or a temporary film during DRIE etch.

After addition of the second dielectric layer 32 and/or the deposited layer 33, a lithography defining pattern for back side cavity etching can be performed. All layers at the back side, e.g., the second dielectric layer 32 and the deposited layer 33, are etched away within a cavity pattern 34, as shown in FIG. 5. The cavity pattern 34 can define a width of a cavity eventually formed in the wafer 15.

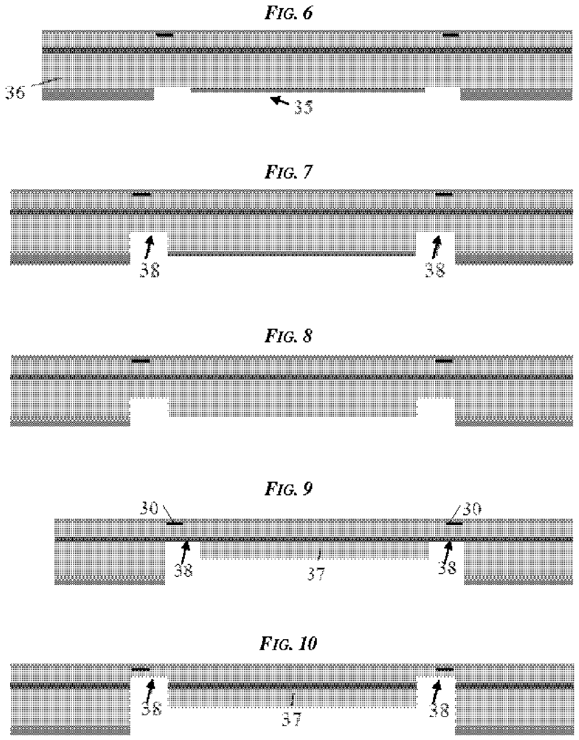

Next, lithography can define a central boss pattern on the back side of the wafer 15. As shown in FIG. 6, a photoresist 35 can cover a frame 36 of the die and an area inside the cavity pattern 34 where a central boss 37 (see FIGS. 9 and 10) will be formed. DRIE can then be used to etch a trench 38 from the back side of the wafer 15, as shown in FIG. 7. The trench 38 corresponds to a thin diaphragm area in the final die structure. A depth of the trench is determined by several factors discussed later. The photoresist 35 can then be removed from the wafer 15, as shown in FIG. 8, and second DRIE step can be used to continue etching the wafer 15 from the back side. During the second DRIE step, both the trench 38 and the central boss 37 are etched. At the end of the second DRIE, the trench 38 is etched through the handle layer 14, and the second DRIE etching stops at the dielectric layer 12, as shown in FIG. 9. The second DRIE etching can be non-uniform across the wafer 15. Therefore, some over-etching can be performed during the second DRIE to make sure that etching stops at the dielectric layer 12 everywhere across the wafer 15. The second dielectric layer 32 and the deposited layer 33 can provide adequate protection of the back side of the wafer 15 during this second DRIE etching. The wafer 15 as shown in FIG. 9 can be the final sensor die.

In some embodiments, as shown in FIG. 10, the wafer 15 of FIG. 9 can be further processed by etching off the dielectric layer 12 at the bottom of the trench 38 or both etch off the dielectric layer 12 at the bottom of the trench 38 and thin down part of the elastic element in the trench 38. The dielectric layer 32 and the deposited layer 33 provide adequate protection of the back side of the wafer during this etching.

Some over-etching might be performed in the second DRIE of FIG. 9 when etch stop at the dielectric layer 12 occurs. Over-etching can be equivalent to etching time required to etch certain amount of silicon. For example, over-etching can be equivalent to about 10% or about 20% of overall DRIE etching time, and correspondingly, target final boss height can be chosen in such a way that its height is at least not smaller than a minimum acceptable boss height even after about 10% or about 20% overetching at the second DRIE step of FIG. 9.

As can be seen from FIGS. 9 and 10, the stress-sensitive components 30 can be located on the front side of the wafer 13 above the trench 38. Therefore, when a pressure is applied to the diaphragm, then the trench 38 can act as a stress concentrator, and the stress-sensitive components 30 can generate electrical signal proportional to pressure. A width of the trench 38 can be small and, therefore, transduction characteristic of the stress-sensitive components 30 can be linear.

In some embodiments, the trench 38 can be etched through the handle layer 14 in the DRIE of FIG. 7 without performing the steps shown in FIGS. 8 and 9. Moreover, the dielectric layer 12 can be etched off after that etching of the trench 38 and the diaphragm can be thinned down in the trench 38. However, as mentioned above, it can be beneficial to have a width of the trench 38 significantly smaller than the linear dimension of the diaphragm so as to decrease pressure sensor non-linearity. Therefore, width of the trench 38 can be also significantly smaller than wafer thickness. As a result, high-aspect ratio DRIE trenches 38 can be etched in the DRIE of FIG. 7.

An aspect ratio of the trenches formed using the process of FIGS. 2-9 and the process of FIGS. 2-10 can be much smaller than in the case of etching trenches through the entire thickness of the wafer in the DRIE of FIG. 7. Therefore, both dimensions and mechanical properties of the resulting structure formed shown in FIG. 9 can be better controlled and better reproduced, which, in turn, allows for better reproducibility of pressure sensor parameters and thus better performance of the low pressure sensor.

FIG. 11 shows another embodiment of a sensor die 40 configured for low pressure sensing. The die 40 can be fabricated from a uniform silicon substrate, e.g., a non-SOI substrate. The die 40 can include a frame 41, a diaphragm 42 or elastic element 42 that includes a thin area 43 and two bosses 44, a cavity 39, and a plurality of stress sensitive components 46, 47 located within the thin area 43. The stress sensitive components 46, 47 can be connected to a sensing circuit and can be configured to change their parameters in response to stress caused by applied pressure.

The bosses 44 can be thicker than the thin area 43 of the diaphragm 42 and can be substantially thinner than the frame 41. For example, a thickness of the thin area 43 can be in a range of 1 to 20 $\mu$m, e.g., in a range of 1 to 10 $\mu$m, and a thickness of the bosses 44 can be at least 1.5 times greater than the thickness of the thin area 43, e.g., greater than 2.0 times greater than the thickness of the thin area 43, in a range of about 1.5 to 3.0 times greater than the thickness of the thin area 43. The bosses 44 shown in the embodiment of FIG. 11 have a rectangular shape. Side walls of the bosses 44 can be substantially parallel to each other and to edges of the diaphragm 42, as shown in the embodiment of FIG. 11. However, the shape of the bosses 44 can be different, and the side walls of the bosses 44 can be non-parallel to the edges of the diaphragm and non-parallel to each other. A length of the bosses 44 can be significantly greater than a distance between the bosses 44 and the frame 41. A distance between the bosses 44 in a central area of the diaphragm 42 can be significantly less than the length of the bosses 44. Therefore, the thin area 43 can have two narrow side grooves 48 defined between the bosses 44 and the side walls 45 of the cavity and one narrow central groove 49 defined between the bosses 44 in the center of the diaphragm. At least one of the stress sensitive components 46 can be located in the side grooves 48, and at least one of the stress sensitive components 47 can be located in the central groove 49.

The cavity 39 has side walls 45 that can be non-parallel to the side walls of the bosses 44. The cavity's side walls 45 can form an angle of atan(sqrt(2)/2) $\approx$ 35°16' with a back surface of the substrate.

Although the die 40 of FIG. 11 has two bosses 44, a sensor die 40 can have another number of bosses, e.g., one, three, four, etc. Similarly, a sensor die 40 can have an elastic element having a shape other than the rectangular shape shown in the embodiment of FIG. 11. For example, a sensor die can include an elastic element having a square shape with one central boss located symmetrically with respect to two axes of symmetry of the elastic element. For another example, a sensor die can include an elastic element having a polygonal shape with at least one axis of symmetry with two rectangular bosses located symmetrically with respect to the at least one axis of symmetry.

A sensor die, such as the die 40 of FIG. 11 can be formed using a fabrication process that includes wet etching of the substrate. FIGS. 12-17 illustrate one embodiment of such a fabrication process. The process can use a selective silicon micromachining process having a strong dependence of etch rate on impurity concentration or some other parameters determined by impurity concentration. This can allow for either significant decrease of etch rate or etch stop at the interface between the diffused layer and body of the substrate. In particular, a difference in concentration of carriers in the elastic element and in the substrate can be used to define a desired shape of the sensor's elastic element. Both a type of doping and a target impurity concentration can depend on the chosen type of selective micromachining process. For example, if an electrochemical etching of silicon is used as the micromachining process, then a p-n junction can be formed. Therefore, n-type doping can be used in a case of p-type starting material, and p-type doping can be used in a case of n-type starting material to form a desired mechanical structure. In a case of etch stop being achieved due to a certain level of impurity concentration, then the required type of impurity can be used and the doping / drive-in process discussed further below can be designed to provide the required concentration. For example, in some etchants, e.g., ethylenediamine with pyrocathehol (EDP), etch rate of monocrystalline silicon can depend on a concentration of impurity and etching can stop at a certain concentration of impurity.

FIG. 12 shows a non-SOI substrate 51 in an initial state. As shown in FIG. 13, a plurality of boss areas 54, 55 can be doped on a front side 52 of the wafer 51 followed by a drive-in of impurity. The boss areas 54, 55 can be used to form bosses in the final structure. The doping can form a transition to the substrate material that can be used as an etch stop during micromachining, discussed below. The first doping can be performed using ion implantation or diffusion. A dielectric layer can be used as a mask during diffusion. For example, silicon dioxide can be used as the mask. A dielectric layer, a photoresist, or a combination of a dielectric layer and a photoresist can be used as a mask to allow for local ion implantation in the plurality of boss areas 54, 55. The first doping can be followed by impurity drive-in.

After the local doping to form the boss areas 54, 55, the front side 52 of the wafer 51 can be doped, followed by a drive-in to create a layer 56, as shown in FIG. 14. The layer 56 can cover the entire front side 52. In some cases, a flash implant can be performed on the front side 52 of the substrate 51, as also shown in FIG. 14. Either diffusion or ion implantation can be used for doping of the layer 56. Portions of the layer 56 will form a thin area of the diaphragm in the final structure. The layer 56 can thus have the required conductivity and concentration of carriers for the thin area. Both the layer 56 and the pre-boss areas 54, 55 can be affected by the second doping and the drive-in. Because of the first drive-in performed after the first doping, impurity diffuses deeper into substrate 51 in the boss areas 54, 55 than in the layer 56.

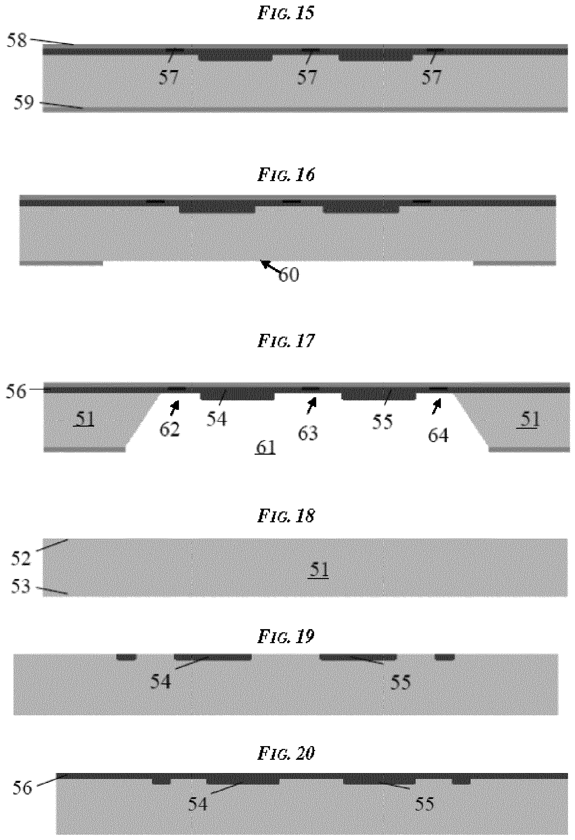

As shown in FIG. 15, the wafer 51 can then have a first dielectric layer 58 formed on the front side 52 of the wafer 51 and a second dielectric layer 59 formed on a back side 53 of the wafer 51. The first and second dielectric layers 58, 59 can have the same or different thicknesses and compositions. The second dielectric layer 59 can be a good mask for a subsequent micromachining process. For example, a layer of silicon nitride can be used as a mask in a case of wet anisotropic etching in base solutions or solutions containing amino-group. Other dielectric, semiconductor or metal layers can be used as a mask when micromachining. As also shown in FIG. 15, stress-sensitive components 57 can be formed within the layer 56. The wafer 51 can have electrical contacts (not shown) to the stress-sensitive components 57 connected to metal pads (not shown) for external electrical connections to the sensor chip.

Substrate micromachining can next be performed, as shown in FIGS. 16 and 17. An opening 60 can be formed in the second dielectric layer 59 at the back side 53 of the substrate 51, as shown in FIG. 16. Next, as shown in FIG. 17, a cavity 61 can be etched in the substrate 51 using wet micromachining or wet etching, e.g., wet anisotropic etching. The etching stops at an interface between the layer 56 with bosses 54, 55 and a remaining part of substrate 51 not being affected by the doping. The etching may stop close to the interface instead of exactly at the interface but nevertheless be considered to stop at the interface due to, e.g., manufacturing tolerances. The wet etching can result in first and second grooves 62, and 64 being formed between the bosses 54, 55 and the frame 51 and a third groove 63 formed between the bosses 54, 55.

Each of the grooves 62, 63, 64 can have at least one of the stress-sensitive components 57 positioned thereabove. In this way, when a pressure is applied to the diaphragm, then the grooves 62, 63, 64 can act as stress concentrators and the stress-sensitive components 57 can generate electrical signal proportional to pressure. A width of the grooves 62, 63, 64 is small as formed by the process, and, therefore, a transduction characteristic of the low pressure sensor is linear.

Chemical etch rate during a wet micromachining process can be slower when etching happens in the areas of the wafer 51 in which the grooves 62, 63, 64 are formed. As will be appreciated by a person skilled in the art, this can happen due to etch rate variation related to the shape of the structure. As will also be appreciated by a person skilled in the art, chemical reactions between a fluid and a solid at the surface of a solid include the following steps: transport of reagents to the surface of the solid, adsorption of reagents at the surface of the solid, chemical reaction itself at the surface where products are formed, desorption of the products from the surface of the solid, and transport of the products from the surface of the solid. The transport of reagents to the surface of the solid and the transport of the products from the surface of the solid can be governed by the laws of diffusion, while the adsorption of reagents at the surface of the solid, the chemical reaction itself at the surface where products are formed, and the desorption of the products from the surface of the solid can be characterized by activation energy and governed by the Arrhenius equation. In general, etch rate is determined by the slowest step. An electric field in the case of electrochemical etching can affect the speed of diffusion. Therefore, in forming the product of FIG. 17, if the etch rate is determined by diffusion, then the etching of silicon within the grooves 62, 63, 64 can be slower than in other areas of the wafer 51, e.g., in other areas of the diaphragm.

As will be appreciated by a person skilled in the art, according to the Arrhenius equation, rate of reaction depends on temperature T as exp(-Ea/kT), where Ea = activation energy and k = the Boltzmann constant. Dependence of diffusion coefficient in fluids on temperature is typically not as strong as temperature dependence of the rate of chemical processes. Therefore, in different temperature ranges, both diffusion and adsorption / chemical reaction / desorption can control the rate of chemical etching process. In forming the product of FIG. 17, if the rate of chemical reaction is not determined by diffusion processes, then the etch rate can be very similar in all areas, and diaphragm thickness can be uniform because temperature in all areas also can be very uniform. Selecting parameters of the etching process in such a way that the rate of reaction is not controlled by diffusion of reagents or products of reaction allows for the diaphragm to have uniform thickness of the bosses 54, 55 and the thin diaphragm area.

Similar to that discussed above with respect to the process of FIGS. 9-10, additional etching steps can be performed after the etching of FIG. 17.

A combination of etching steps utilizing different etching methods can be used for substrate micromachining. For example, a combination of DRIE and wet etching can be employed in order to make the sensor die even smaller, as discussed further below.

The process of FIGS. 12-17 can provide good reproducibility and uniformity of the diaphragm layer thickness and boss thickness because of very high reproducibility of diffusion processes and long process time, which can allow for control of both boss shape / thickness and diaphragm layer thickness. The process of FIGS. 12-17 does not require expensive equipment for epitaxial growth, as is used in manufacturing of some traditional low pressure sensors, and can allows for fabrication of the low pressure sensor using standard wafer fabrication equipment. In the process of FIGS. 12-17, both microstructure design and circuit design flexibility is provided since only some areas on the surface of the wafer need be doped. Therefore, the process can be used to form at least one p-doped area and at least one n-doped area on the surface of the die, which can be beneficial for fabrication of some electrical components, such as resistors, diodes, and transistors, on the same wafer.

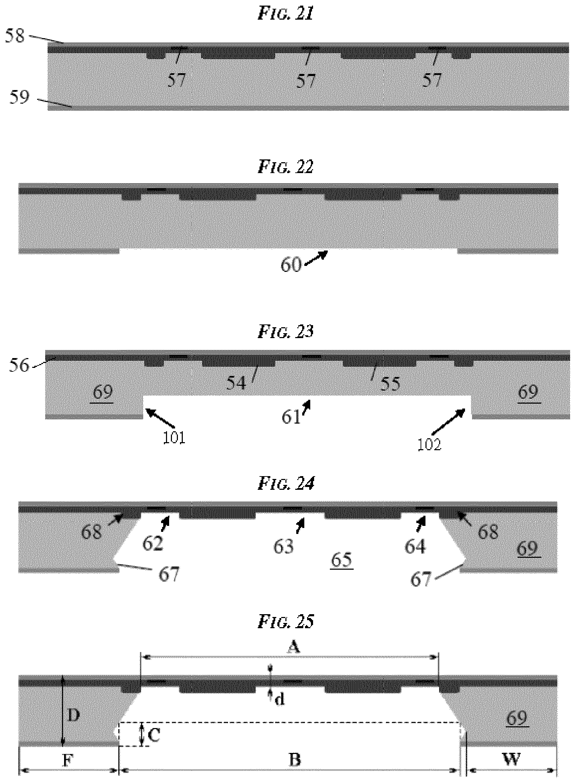

FIGS. 18-25 illustrate another embodiment of a fabrication process that can be used to fabricate a sensor die having substantially vertical boss side walls and non-parallel cavity side walls. In the process of FIGS. 18-25, both DRIE and wet etching, e.g., wet anisotropic etching, are used on the wafer 51 to form a diaphragm of a sensor die. The processing shown in FIGS. 18-22 is the same as the processing shown in FIGS. 12-16, except for a size of an opening 60 in FIG. 22 for diaphragm etching, and is therefore not again discussed. The size of the opening 60 in FIG. 22 is less than a size of the opening 60 for diaphragm etching in FIG. 16.

After the forming of the opening 60 of FIG. 22, the wafer 51 can be micromachined using DRIE, as shown in FIG. 23. The DRIE can begin forming a cavity 65 in the wafer 51. The portion of the cavity 65 formed by the DRIE can have opposed substantially vertical side walls 101, 102 that are substantially perpendicular to substantially parallel top and bottom surfaces of the wafer 51. As discussed further below, a depth of the portion of the cavity 65 etched using DRIE and the size of the opening 60 depend on a target size for the sensor die's diaphragm.

After the DRIE, the wafer 51 can be wet etched, e.g., using wet anisotropic etching, to further form the cavity 65, as shown in FIG. 24. The wet etching can stop at an interface between the doped layer 56 with the bosses 54, 55 and a remaining part of substrate 51 not being affected by the doping. The wet etching may stop close to the interface instead of exactly at the interface but nevertheless be considered to stop at the interface due to, e.g., manufacturing tolerances. Similar to that discussed above, the wet etching can result in grooves 62, 63, 64 being formed and each of the grooves 62, 63, 64 can have at least one of the stress-sensitive components 57 positioned thereabove.

The wet etching can cause the side walls of the cavity 65 to no longer include the opposed substantially vertical side walls 101, 102. The cavity 65 can have a side wall portion 67 with a negative angle. The negative angle side wall portion 67 can be formed as a result of etching a profile with the vertical side walls 101, 102 formed by the DRIE. (111) planes that form the side walls of the cavity 65 form an angle of $\mathrm{atan}(\mathrm{sqrt}(2)/2) \approx 35°16'$ with (100) planes defining the back side and the front side of the wafer 51. The planes that form the side walls of the cavity 65 start developing along the vertical side walls 101, 102 of the DRIE-etched portion of the cavity 65 during the wet etching. The etch rate of the (111) planes that form the side walls of the cavity 65 is considerably lower than etch rate of the (100) planes defining the back side and the front side of the wafer 51. The ratio can be in a range of 0.03 to 0.002. Therefore, it is possible to neglect the etch rate of the planes that form the side walls of the cavity 65 in an approximate geometrical analysis of the resulting structure shown in FIGS. 24 and 25.

As shown in FIG. 25, presence of the side wall portion 67 with a negative angle makes a minimum width W of the die side wall less than a width of frame width F on the back side of the wafer 51.

In the structure of FIG. 25, a substrate thickness is equal to a variable D, and final diaphragm thickness is equal to a variable d. In FIG. 25, a dotted line shows a position of the cavity 25 etched by DRIE, e.g., an outline of the portion of the cavity 65 shown in FIG. 23. This portion of the cavity has a depth equal to a variable C. Taking into account the angle between the planes that form the side walls of the cavity 65 and the planes defining the back side and the front side of the wafer 51, it can be seen that a size of the diaphragm, represented by a variable A, is related to a size of the opening 60, represented by a variable B, for cavity etch and depth of DRIE-etched cavity as shown in the following equation:

$$B = A + (D - C - d)*\mathrm{sqrt}(2) .$$

There are two limit cases to the equation. First, if the diaphragm is formed only by wet etching, e.g., without DRIE, then the opening B is the biggest:

$$B\max = A + (D - d)*\mathrm{sqrt}(2) .$$

Second, if the diaphragm is formed mostly by DRIE, then the smallest opening B can be close to the size of the diaphragm:

$$B\min \approx A .$$

Correspondingly, a size of the die can be decreased when DRIE is used in diaphragm micromachining.

The DRIE has some non-uniformity across the wafer 51, and the etch depth C can vary from wafer to wafer and from wafer lot to wafer lot. Etch depth non-uniformity ΔC is translated to variation of the diaphragm size:

$$\Delta A = \Delta C*\mathrm{sqrt}(2) .$$

This variation is undesirable because it affects position of stress sensitive components, e.g., piezoresistors, with respect to the edge of the diaphragm and can impact sensitivity of the stress sensitive components. In order to minimize this negative effect, the structure of FIGS. 24 and 25 has thin frame areas 68 formed with the bosses 54, 55. Location of the thin frame areas 68 can be chosen in such a way that edges of the diaphragm after the wet etching always lands in the thin frame areas 68. Being significantly thicker than the diaphragm, the thin frame areas 68 can act as a portion of a frame 69 of the sensor die and, consequently, a position of the diaphragm edge and width and location of the grooves 62, 63, 64 can be well defined and do not depend on position of the side wall defined by the wet etching within the thin frame areas 68.

The frame 69 is defined by areas having about the same thickness as thickness of the initial substrate of FIG. 18. The thin frame areas 68 can be effectively used as a part of the frame 69 only if variation of diaphragm size ΔA is not significantly greater than thickness of the thin frame areas 68. For example, if boss thickness and the thickness of the thin frame areas 68 is 15 $\mu$m, then a maximum range of diaphragm size variation 2*$\Delta$A can be evaluated as 15 to 22.5 $\mu$m, e.g., 1.0 to 1.5 times of thickness of the thin frame areas 68. If the range of diaphragm size variation 2*$\Delta$A exceeds these limits, then bending of the thin frame areas 68 in response to applied mechanical stress, e.g., pressure, can adversely affect performance of the sensor die.

By way of example, a pressure sensor die formed by wet anisotropic etching can have a size of 2.20 mm x 2.20 mm x 0.50 mm with a die area of 4.84 mm$^2$, a diaphragm size of 1.0 mm x 1.0 mm x 0.015 mm, and a thickness of bosses 54, 55 and frame areas 68, 69 of 0.03 mm. Using the formulas above, a width of the cavity on the back side of the die is equal to 1.0 mm + (0.50 mm - 0.02 mm)*sqrt(2) $\approx$ 1.68 mm, and frame width on the back side of the die is about 0.26 mm. The minimum width of die side wall can be limited by 0.15 mm and etch depth variation due to non-uniformity and non-reproducibility of DRIE equal to $\pm$5% of the etch depth C. By using the above formulas, die size can be decreased to 1.80 mm x 1.80 mm, die area can be decreased to 3.24 mm$^2$, which is about 33% smaller than the area of 2.20 mm x 2.20 mm die. DRIE etch depth C can be equal to 0.27 mm, and cavity opening B can be equal to 1.305 mm, which can allow minimum side wall thickness to be kept at 0.15 mm. With this DRIE target etch depth, etch depth variation can be $\pm$0.0135 mm. The range of diaphragm size variation 2*$\Delta$A can be 0.019 mm, which is smaller than thickness of the frame areas 68, 69 (0.03 mm). Therefore, DRIE etch depth non-uniformity will not affect performance of the die.

FIG. 26 shows another embodiment of a sensor die 70 configured for low pressure sensing. The die 70 can also be configured to measure flow. In many cases there is a direct relationship between pressure and flow, and thus the die 70 can be calibrated in either pressure units or flow units.

The die 70 can include a substrate that forms a frame 71, a cavity that is formed in a bottom side of the substrate and that defines an elastic element 72 including a thin diaphragm area 77 and at least one rigid island 73. The die 70 in this illustrated embodiment includes two rigid islands 73. The bosses 73 in the embodiment of FIG. 26 are formed using wet etching, such as the process discussed above with respect to FIGS. 11-17. However, the bosses 73 can be formed either using DRIE micromachining, e.g., as described with respect to FIGS. 2-10, or using combination of DRIE and wet etching micromachining, e.g., as described with respect to FIGS. 18-25. The bosses 73 can be separated from the frame 71 by peripheral grooves 74 and from each other by central groove 78. The elastic element 72 can have a plurality of stress concentrators 75, 79 formed therein, e.g., in the thin diaphragm area 77. In this illustrated embodiment, the plurality of stress concentrators 75 includes a plurality of recesses 75, 79 formed in the elastic element 72. Stress concentrators in the diaphragm 72 reduce the stiffness of the diaphragm 72 and increase the sensitivity of the sensor. As a result, a small pressure drop on the diaphragm can create large stress in the diaphragm, and the stress can be detected by the die's stress sensitive components 76. The recesses 75, 79 can be formed in a variety of ways, such as by etching.

As illustrated in FIG. 26, the sensor die 70 may include recesses 75 formed in along a peripheral edge of the elastic element 72 (e.g., in a center portion of two opposite edges of the elastic element 72). When a uniform diaphragm is loaded by pressure, then the areas with the maximum stress are located at the edges of the diaphragm in the center of each side. By forming the recesses 75 in the center portion of the two opposite edges of the elastic element 72, the stiffness of the elastic element 72 can be significantly reduced as compared to an elastic element without stress concentrators.

Additionally or alternatively, the sensor die 70 may include recesses 79 formed in the thin area 77 of the elastic element 72 opposite the peripheral groove 74 and/or the central groove 78 of the cavity. A recess 79 may be formed along (i.e., substantially aligned with) a central axis of the thin area 77 (i.e., an axis equidistant between a peripheral edge of the elastic element 72 and peripheral edge of a rigid island 73 or an axis equidistant between two elastic elements 72). Depending on geometry of elastic element, recesses 79 that are formed in the thin area 77 of the elastic element 72 opposite the peripheral groove 74 and/or the central groove 78 of the cavity may be more effective in reducing the stiffness of the elastic element 72 (and increasing sensitivity of the sensor die 70) than recesses 75 that are formed in the center portion of opposite sides of the elastic element 72.

The depth of the recesses 75, 79 may be at least half the depth of the thin area 77 of the elastic element 72.

As illustrated in FIG. 26, the recesses 75, 79 may have a rectangular shape with a long dimension and a shorter dimension. The recesses 79 may be parallel to a central axis of the thin area 77 (i.e., the long dimension of the recess 79 may be substantially parallel to the central axis of the thin area 77). Alternatively, the recesses 79 may be perpendicular to the central axis of the thin area 77 (i.e., the long dimension of the recess 79 may be substantially perpendicular to the central axis of the thin area 77). In other embodiments the recesses 75 and 79 may have other (non-rectangular) shapes. For example, the recesses 75 and 79 may have a square shape, an L shape, a polygonal shape, a circular shape, or an oval shape. As illustrated in FIG. 26, the recesses 75 and 79 each have right angle corners. In other embodiments, however, the recesses 75 and 79 may have rounded corners. Stress concentrators having rounded corners can help minimize stress concentration in areas adjacent to the recesses.

The cavity and/or rigid island(s) may be pyramidal with at least two side walls having (111) crystallographic orientation. Additionally or alternatively, the cavity and/or rigid island(s) 73 may be prism-shaped with side walls making angle from 85 degrees to 95 degrees with respect to the bottom of the cavity or rigid island(s) 73. For example, the sensor die may include a pyramidal cavity with one or two pyramidal rigid island(s) 73, a prism-shaped cavity with one or two prism-shaped islands 73, a pyramidal cavity with one or prism-shaped rigid island(s) 73, etc.

In some applications, a diaphragm or an elastic element of a pressure sensor separates fluids or other media which are loaded with different pressures. One side of the elastic element is facing a media having a first pressure, and the other side of the elastic element is facing a media having a second, different pressure. The pressure sensor responds to the difference between the first and the second pressures. In other applications, an elastic element may not need to separate media on both sides of the elastic element. For example, in some medical applications, air pressure is measured during breathing and measurements of relative air pressure between different areas / compartments in a structure do not require separation of media. In applications where an elastic element need not separate media on both sides of the elastic element, the elastic element can have holes formed therein such that media is not prevented from passing from one side of the elastic element to the other side of the elastic element. For example, in a heating, ventilation, and air-conditioning (HVAC) system, such as in a clean room, an elastic element used in measuring air or other gas pressure can have holes therein.

FIG. 27 shows another embodiment of a sensor die 80 configured for low pressure sensing and configured to measure flow. The die 80 can generally be configured similar to the die 70 of FIG. 26 and can include a substrate that forms a frame 81, a cavity that is formed in a bottom side of the substrate and that defines an elastic element 82 including a thin area 87 and at least one rigid island 83, a plurality of stress sensitive components 86, 88, 89 located within the thin area 87, and a plurality of stress concentrators 85 formed in the elastic element 82, e.g., in the thin area 87. The die 80 of FIG. 27 includes a single boss 83 surrounded by a single groove 84, which defines the thin area 87 of the elastic element 82. The stress concentrators 85 in this illustrated embodiment include holes 85 formed through the thin area 87 of the elastic element 82. Thus, as opposed to the recesses 75 and 79 of FIG. 26, which only extend through a partial depth of the elastic element 72, the holes 85 of FIG. 27 extend entirely through a depth of the elastic element 82. The holes 85 each have an L-shape, but as mentioned above with respect to the recesses 75 and 79 of FIG. 26, stress concentrators can have other shapes. The holes 85 can be formed in a variety of ways, such as by etching.

The holes 85 are located at each of the diaphragm's four corners (one corner is a cut away portion of the die 80 is not shown in FIG. 27). Stress from applied pressure at the corners of the elastic element 82 is low. Therefore, the holes 85 do not create dangerous stress concentrators. The holes 85 could additionally or alternatively be formed in a center portion of two opposite sides of the elastic element 82 similar to the recesses 75 of FIG. 26. Similarly, the recesses 75 of FIG. 26 could additionally or alternatively be located at corners of the diaphragm 72. Further, the recesses 75 and 79 of FIG. 26 and the holes 85 of FIG. 27 can be formed in other locations to decrease diaphragm stiffness and increase sensor sensitivity, such as along an edge of an elastic element and/or in areas adjacent to bosses.

If the holes 85 at the corners of the elastic element 82 are sufficiently long, the released corners of the elastic element 85 can bend up and/or down in response to mechanical stress. A direction of the bending and a maximum amount of bending of the released corners can be taken into account to minimize adverse affects related to temperature dependence and, if applicable, can be taken into account to minimize interference with a cap attached to the sensor die, as discussed below. An area of the holes 85 and resistance to fluid flow will depend on temperature if bending of the released corners of the diaphragm 82 depends on temperature.

When a sensor includes stress concentrators and stiffness of the die's elastic element decreases, the structure becomes more sensitive to inertial forces and, therefore, more sensitive to vibrations. This sensitivity to vibrations can be used in a variety of different applications. For example, both pressure / flow and vibration can be measured using the same sensor die. Low pressure typically does not change fast. Hence, low pressure can typically be measured with a narrow bandwidth, such as a bandwidth of 0 to 10 Hz. In contrast, vibrations typically have a wider bandwidth and can often be heard by the human ear. However, noise generated due to vibrations can typically be heard only if frequency of corresponding harmonics is higher than a frequency in a range of 17 to 25 Hz. Therefore, it can be possible to obtain information about both about pressure / flow and vibrations by filtering an output signal of the sensor, e.g., by separating lower frequency and higher frequency components. These two parameters can be measured using two circuits on the same die, with one circuit for pressure / flow measurement and another circuit for vibration measurement. The die 80 of FIG. 27 is one embodiment including multiple stress-sensitive components 88, 89 with some of the stress-sensitive components, e.g., the stress-sensitive components 88 on opposed sides of the diaphragm 82, being be used in a circuit for pressure / flow measurement and a remainder of the stress-sensitive components, e.g., the stress-sensitive components 89 on the other two opposed sides of the diaphragm 82, being used in a circuit for vibration measurement. Also, a relatively large boss, such as the single boss 83 shown of FIG. 27, can facilitate vibration measurement. As will be appreciated by a person skilled in the art, acceleration measured in vibration measurements can be characterized by three components of acceleration vector, and a number of stress sensitive components used for vibration measurement can be chosen accordingly.

SOI material or non-SOI material can be used as starting material for fabricating a sensor die including stress concentrators. FIGS. 28-32 illustrate an embodiment of a fabrication process that can be used to fabricate a sensor die including stress concentrators in the form of holes. The embodiment of FIGS. 28-32 uses non-SOI material as starting material.

FIG. 28 shows a substrate 90 of silicon in an initial state. The wafer 90 can be processed to enable etch stop during back side micromachining of the die's elastic element, similar to that discussed above with respect to FIG. 17, and to form stress-sensitive components 93 on a front side 91 of the wafer 90, similar to that discussed above with respect to the stress-sensitive components 30 of FIG. 3. The processed wafer 90 is shown in FIG. 29. As a result of the processing, the wafer 90 can have doped layers that define a thickness of a thin diaphragm area (not shown), electrical contacts (not shown) to the stress-sensitive components 93, the stress-sensitive components can be connected to metal pads (not shown) for external electrical connections to the sensor chip, and the wafer 90 can have a first dielectric layer 94 on the front side 91 thereof and a second dielectric layer 95 on a back side 92 thereof. The first and second dielectric layers 94, 95 can be the same, or the first and second dielectric layers 94, 95 can have different thicknesses and/or different compositions.

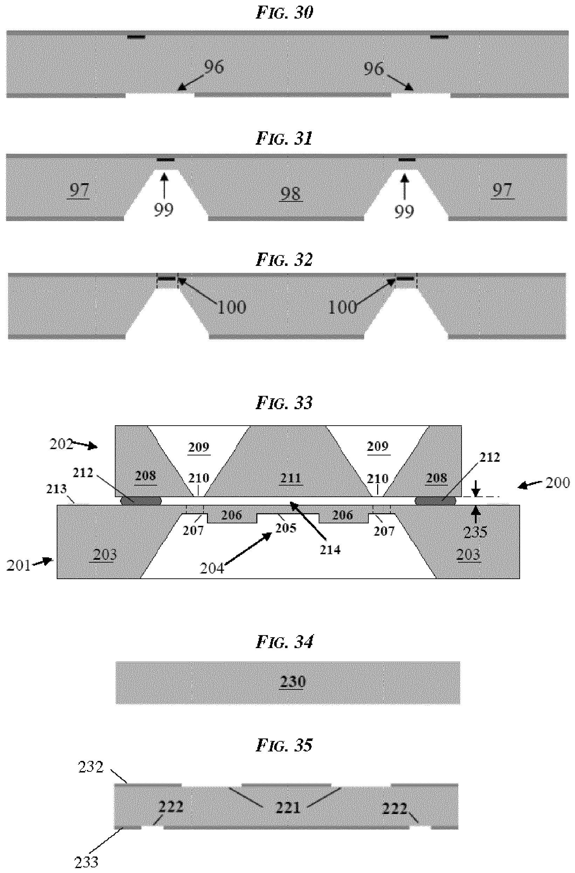

Next, as shown in FIG. 30, a lithography defining pattern 96 can be provided for back side cavity etching, and the second dielectric layer 95 can be etched away within the pattern 96. Micromachining can then be performed using dry etching, wet etching, isotropic etching, or any combination thereof. FIG. 31 shows the structure after micromachining. The micromachining can define a frame 97 of the die and can define an elastic element including a central boss 98 and a thin area 99. The stress-sensitive components 93 can be located within the thin area 99.

Next, stress concentrators in the form of holes 100 can be formed in the elastic element, as shown in FIG. 32. The holes 100 can be etched from the front side 91 of the wafer 90. The etching can be DRIE. The front side 91 of the wafer 90 can be protected during the etching by photoresist or by other material that has high selectivity to silicon during the etching process. For example, a layer of low temperature oxide, thermally grown silicon dioxide, low pressure chemical vapor deposition (LPCVD) silicon nitride, plasma-enhanced chemical vapor deposition (PECVD) silicon nitride, metal layer, or any combination thereof can be used as mask during the etching. The holes 100 can be formed either before or after the back side etching. Opening the hole pattern for etching on the front side 91 before back side micromachining can be beneficial for process integration, though this order of steps can requires protection of the hole pattern during back side micromachining.

An embodiment of a process using SOI starting material is described above with respect to FIGS. 2-10. Holes can be added to a wafer formed in such a process similar to that discussed above regarding FIG. 32.

After the back side micromachining, a wafer having holes formed therein can be fragile. The wafer may therefore need special handling to prevent wafer damage, which can make wafer processing more complex. In order to minimize inconvenience related to the special handling, the wafer can be bonded to a temporary carrier or to a non-temporary carrier, e.g., a glass carrier or a silicon substrate that is used as a part of a final product that includes the device wafer with through holes. The bonding can be performed before the etching of the holes. The carrier, whether temporary or non-temporary, can provide additional strength to the wafer, minimize yield loss, and/or simplify requirements of the special handling. For example, a piezoresistive pressure sensor can include a wafer with stress-sensitive components bonded to a carrier.

Stress concentrators can weaken the structure of the elastic element. The elastic element can thus be vulnerable to damage from mechanical force that can be applied to the structure during fabrication of the sensor die, such as during wafer sawing, and/or vulnerable to contamination with slurry using during fabrication. The sensor die can thus be provided with a cap configured to protect the elastic element from damage during fabrication. The cap can also be configured to protect the elastic element from pressure and/or shock overload during use of the sensor die in sensing physical parameter(s). A cap can be used with a sensor die that does not include stress concentrators, which can protect the die's diaphragm from pressure and/or shock overload during use of the sensor die in sensing physical parameter(s), as diaphragms used for low pressure sensing can generally be relatively fragile.

FIG. 33 shows another embodiment of a sensor die 200 configured for low pressure sensing that includes a cap. The sensor 200 die includes two layers, a device wafer layer 201 and a cap wafer layer 202, that are bonded to one another with a bond layer 212.

The device wafer layer 201 can have different configurations, such as any of the sensor dies disclosed herein. For example, the sensor's elastic element can have no recesses and no holes, have recesses but no holes, have both recesses and holes or have holes and no recesses. The device wafer layer 201 in this illustrated embodiment includes a frame 203, one or more bond pads 213 on a top surface of the frame 203, and an elastic element 204 having thin areas 205, bosses 206, and holes 207. The one or more bond pads 213 can be configured to attach to one or more wires (not shown) to facilitate transmission of data and other communication with the sensor circuit, as will be appreciated by a person skilled in the art. A portion of the cap wafer layer 202 can be removed to provide access to the bond pads 213 located on the device wafer layer 201. A distance from the bond pads 213 to the cap wafer layer 202 can be large enough to enable wire bonding, e.g., a minimum distance in a range of 0.20 to 0.30 mm. Any of the sensor dies disclosed herein can include one or more bond pads whether or not a cap is bonded to the sensor die.

The bond layer 212 can provide a liquid-proof bond for the device and cap wafer layers 201, 202. A bonding area defined by the presence of the bond layer 212 does not overlap with the elastic element 204 in order to avoid interference with bending of the elastic element 204 in response to mechanical stress. In other words, the bond layer 212 can be attached to the frame 203 of the device layer 201 and not to the elastic element 204.

The cap wafer layer 202 can include a frame 208, a central portion 211, and one or more holes 209 on either side of the central portion 211. An entirety of each of the openings 210 can be aligned with one of the holes 209 of the device wafer layer 201, as in the illustrated embodiment, or any one or more of the openings 210 can be laterally offset from the holes 209 such that the opening 210 does not align with the holes 209.

The device wafer layer 201 and the cap wafer layer 202 can be separated by a gap 214. A width of the gap 214 can be defined by a thickness of the bond layer 212. A thickness 235 of the bond layer 212 can be either greater than or less than a target width of the gap 214. The gap width can be adjusted by any one or more of local micromachining of the cap wafer layer 202, by depositing and pattering thin layers on the device wafer layer 201 and/or on the cap wafer layer 202, and by depositing and patterning thin layers in the areas of contact between elastic element 204 and the central portion 211 of the cap wafer layer 202. The width of the gap 214 can be greater than a maximum deflection of the elastic element 204 in an operating range of the physical parameter being measured by the sensor die 200. If the sensor die 200 is configured to measure a plurality of physical parameters, the gap 214 can be greater than a largest maximum deflection among the maximum deflections for the measured parameters' operating ranges. In this way, the gap 214 can be configured to prevent the elastic element 204 from making mechanical contact with the cap wafer layer 202, e.g., with the central portion 211, within the operating range of the parameter being measured. Thus, the elastic element 204 can deflect under normal operation to measure the physical parameter(s) without interference from the cap wafer layer 202. The gap 214 can be less than a maximum deflection of the elastic element 204 at a maximum allowable level of stress in the elastic element 204. In this way, the gap 214 can be configured to allow the elastic element 204 to make mechanical contact with the cap wafer layer 202, e.g., with the central portion 211, in a case of sensor overload with a measured parameter, for example in case of pressure overload. The cap wafer layer 202 can thus directly contact the elastic element 204 when the elastic element is overloaded outside normal operating conditions and can prevent the elastic element 204 from bending any further, thereby helping to prevent the elastic element 204 from breaking or otherwise being damaged. For example, if a low pressure sensor has an elastic element with a maximum deflection of 2.5 $\mu$m in an operating pressure range, and a maximum stress in the elastic element in the operating pressure range is 75 MPa, and a maximum stress in the elastic element should be limited to a range of 250 to 300 MPa, then a width of a gap can be chosen to be in a range of 8 to 9 $\mu$m. A fracture limit for monocrystalline silicon can be close to 1 GPa, so limiting a maximum stress in the elastic element to a range of 250 to 300 MPa can help ensure that the elastic element is not stressed above the fracture limit of silicon.

FIGS. 34-41 illustrate an embodiment of a fabrication process that can be used to fabricate a sensor die including a cap. The sensor die can include a device wafer layer and a cap wafer layer bonded to one another with a bond layer.

FIG. 34 shows a substrate 230 of silicon in an initial state for cap fabrication. Masking layers 221, 222 can be deposited on the cap wafer 230 and patterned on both sides of the wafer 230, as shown in FIG. 35. The patterns 221, 222 can define openings for wafer micro machining. The pattern 221 on a front side of the wafer 230 can be used to etch holes, and the pattern 222 on a back side of the wafer 230 can be used to define a structure that can be used to remove a portion of the cap wafer 230 and expose bond pads (not shown) located on the device wafer and can be used to create a micro-structure for control of a depth of a gap 227 to be formed between the cap and an elastic element of the sensor die. One or more materials can be used as the masking layer, such as silicon dioxide, silicon nitride, metals such as Au, and any combination thereof.

The wafer 230 can have a first dielectric layer 232 on the front side thereof and a second dielectric layer 233 on the back side thereof. The first and second dielectric layers 232, 233 can be the same, or the first and second dielectric layers 232, 233 can have different thicknesses and/or different compositions.

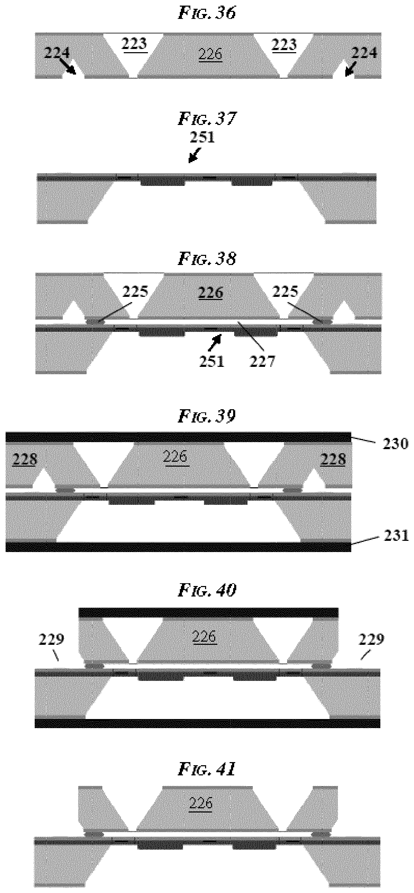

After the masking layers 221, 222 have been patterned, the cap can be micromachined once or twice, depending on requirements to the microstructure for control of depth of a gap between the cap and the elastic element. FIG. 36 shows a cap structure where micromachining has been performed in one etching step using double side etching in solutions for wet etching of silicon, such as bases and etchants with active amino-group, e.g., aqueous solutions of KOH, aqueous solutions of N2H4, etc. The front side pattern 221 can allow for etching through the wafer 230. The etching through the front side pattern 221 can stop at the second dielectric layer 233 at the opposite side of the wafer 230. The second dielectric layer 233 can be removed after the etching of silicon is completed. The holes 223 can be formed as a result of this etching. The back side pattern 222 can allow for etching self-limiting structures, such as V-grooves 224, also referred to herein as dicing grooves, on the opposite side of the cap wafer 230. The V-grooves 224 can have a "V" shape. The grooves 224 can be used later at wafer sawing and can allow for cutting through the body of the cap wafer 230 and for removing portions of the cap wafer 230 located above the bond pads without damaging metal lines on the device wafer layer.

The holes 223 and the dicing grooves 224 can be formed in other ways. For example, the holes 223 can be formed by etching, e.g., dry etching or wet etching, through the wafer 230 from one side of the wafer, as described above with respect to FIG. 36. Similarly, the dicing grooves 224 can be formed in one etching step using dry etching or wet etching. For another example, wet etching of the hole 223 can not done through a full thickness of the cap wafer 230 as in FIG. 36, but instead stop at a predetermined etch depth. After that, the dicing grooves 224 and a pattern for the holes 223 can be DRIE-etched from the opposite side of the wafer 230 with the DRIE stopping when the holes 223 are formed.

The cap wafer can have a shallow recess (not shown) in the bonding area and can have elevated stops (not shown) in an area of potential contact between the elastic element and the central portion of the cap layer. Methods of making such structures are known, as it can be appreciated by a person skilled in the art, and are not particularly discussed.

After cap wafer micromachining, all dielectrics can be stripped off from the cap wafer and the wafer 230 can be cleaned and covered by a new dielectric layer. For example, the cap wafer can be re-oxidized. The stripping of dielectrics, the cleaning, and depositing of a dielectric layer are not shown.

The device wafer layer can be fabricated using any of the processes described above for fabricating a sensor die, e.g., the process of FIGS. 2-9, the process of FIGS. 2-10, the process of FIGS. 12-17, the process of FIGS. 18-25, or the process of FIGS. 28-32. In the illustrated embodiment, a device wafer layer 251, shown in FIG. 37, can be fabricated using the process of FIGS. 12-17 and can have holes formed therein using the process of FIG 32.

The cap of FIG. 36 and the device of FIG. 37 can be bonded together, as shown in FIG. 38. A bonding area 225 that bonds the cap and device wafer layers can be a continuous area or a ring surrounding an elastic element of the device wafer layer. Bonding material can be applied so as to provide liquid-proof sealing of the bonding area 225 between the cap and device wafer layers. Various types of bonding can be used, such as eutectic bonding (e.g., AuSn, AuIn or AlGe eutectic bonding), frit-glass bonding, thermocompression bonding (e.g., Au-to-Au bonding), and polymer bonding.

As shown in FIG. 38, when the cap and device wafer layers are bonded together, a central portion 226 of the cap wafer layer can be facing the elastic element. A width of a gap 227 between the cap and device wafer layers can be chosen to limit deflection of the elastic element when a magnitude of applied stress, e.g., pressure, flow, acceleration from vibration, etc., is outside an operating range of the applied stress and a maximum stress in the elastic element is still within an allowable range therefor. The allowable range can be significantly smaller than the fracture limit for monocrystalline silicon, mentioned above.

Sawing of the bonded wafer stack, e.g., the cap and device wafer layers bonded at the bonding area 225, can be performed as shown in FIGS. 39-41. The resulting structure is shown in FIG. 41. A cut can be made through the cap wafer layer, e.g., using a cutting element such as a saw blade or using laser dicing, and portions 228 of the cap wafer layer located above the bond pads 229, e.g., outermost side portions of the cap wafer layer, can be removed. The cut made through the cap wafer layer can go through the cap wafer layer so as to pass through the dicing grooves 224. Therefore, a depth of the cut can be chosen in such a way that the cutting elements stay adequately far enough from the metal lines and bond pads located in the device layer so as to avoid damaging them. Any long slivers released as a result of the cut through the cap wafer layer can removed from the wafer stack after the cut. These slivers can be either not bonded to the device layer or be bonded in a small number of areas to allow for their effective removal.

As shown in FIG. 39, a first tape 230 can be applied to the cap wafer to close the openings 225 formed in the cap wafer and thus can help protect the elastic element from damage and contamination during the cutting through the cap wafer layer. The first tape 230 can be UV-release tape or thermal release tape, although other types of tape can be used. The first tape 230 can provide liquid-proof sealing of the tape-to-cap wafer interface. Additionally, second tape 231, e.g., standard dicing tape, can provide liquid-proof seal at the interface between the tape and the device wafer. The tapes 230, 231 can help protect the elastic element from water and contamination during the sawing.

After cutting through the cap wafer layer and removing slivers as shown in FIG. 40, a cut can be made through the bonded wafer stack to complete the sawing. After this cut, the die can be removed from the wafer using, e.g., pick and place tools. The first tape 230 can be removed, such as after exposure to UV radiation, for UV-release tape, or after exposure to heat for thermal release tape. A portion of the first tape 230 can be retained on the structure and removes later in the process, which can allow for better protection of the sensor die from contamination and/or can allow for easier pick and place operation at the assembly. For example, thermal release tape can be removed after adhesive curing after die attach or other sensor assembly operation.

The resulting structure of a cap wafer layer bonded to a device wafer layer is shown in FIG. 41.

As mentioned above, an elastic element can be configured to directly contact a cap at a stop area of the cap, e.g., a bottom surface of the cap, when the elastic element is overloaded with a measured parameter, which can help protect the elastic element. The direct contact of the cap and elastic element can, in some instances, cause the elastic element to stick to the cap, such as if the elastic element has a low spring constant and stiction force between two contacting surfaces, e.g., surfaces of the elastic element and cap, is higher than the restoring force that attempts to return the elastic element to its non-deformed position. The stiction force is proportional to the contact area between two surfaces. Adding one or more stop elements to the cap and/or to the device wafer layer that includes the elastic element can limit the contact area between the elastic element and the cap. Therefore, the one or more stops can provide additional protection against damaging the elastic element in a case of overload and can minimize a stiction force between contact surfaces of the cap and the elastic element, e.g., the bottom surface of the cap and the top surface of the elastic element.

As mentioned above, all stop element(s) of a sensor die can be formed on the cap, on the device wafer layer (e.g., to an elastic element thereof), or some can be formed on the cap and some on the device wafer layer. A device wafer layer can have multiple deposition steps (e.g., dielectric, poly-Si, metal, and other layers), and a portion of one of these layers can be used to form the stops during fabrication of the sensor die. Using a portion of one of these layers to form stops does not require additional lithographic and etching steps, while adding stops to the cap wafer layer can require some additional steps during cap wafer fabrication.

A size of the stop elements can vary. A total area of a stop element that can contact a surface opposite thereof, e.g., a bottom surface of the cap (e.g., a bottom surface of a central portion of a cap wafer layer) or a top surface of a device wafer layer (e.g., a top surface of an elastic element), can be chosen such that the stiction force generated across the total area of the stop elements is less than a restoring force, which is the force acting on the deformed elastic element due to potential energy of deformation accumulated in the elastic element and trying to return the elastic element back to its non-deflected position. In some embodiments, the total area of the stop elements can be in a range of 10 to 1000 square $\mu$m.

The stop elements can be formed from a variety of materials. In an exemplary embodiment, the material can be conductive. A conductive material can be less susceptible to charging. Thus, electrostatic forces at an interface between the stop element(s) and another surface, e.g., a central portion of a cap wafer layer, can be minimized.

FIG. 42 shows another embodiment of a sensor die 234 configured for low pressure sensing. The die 234 is the same as the die 200 of FIG. 33 except that the sensor die 234 includes a plurality of stop elements 215. In this illustrated embodiment, the stop elements 215 are formed on the device wafer layer 201, e.g., on the thin areas 205 of the elastic element 204. The stop elements 215 in this illustrated embodiment are located in a central portion of the elastic element 204 such that the stop elements 215 are configured to contact the central portion 211 of the cap wafer layer 202.

In some cases, the inclusion of one or more stop elements can decrease a width of a gap between a cap and an elastic element below a minimum required to prevent the elastic element from directly contacting the cap. For example, if a stop element is formed of metal, metal thickness (e.g., in a range of 0.5 to 1.5 um) can be significant in comparison with gap width. The embodiment of FIG. 43 can address such a situation.

FIG. 43 shows another embodiment of a sensor die 236 configured for low pressure sensing. The die 236 is the same as the die 200 of FIG. 33 except that the sensor die 236 includes a plurality of stop elements 216. In this illustrated embodiment, the stop elements 216 are formed on the device wafer layer 201. The stop elements 216, as shown in this illustrated embodiment, can be located on top of bosses. The stop elements 216 are positioned closer to the periphery of the elastic element 204 than the stop elements 215 in the embodiment of FIG. 42. The stop elements 216 being positioned closer to the periphery of the thin areas 205 can be beneficial where deflection of the elastic element 204 is smaller than in the center thereof. Therefore, contact between stop elements 216 and the central portion 211 of the cap wafer layer 202 will happen at a higher level of pressure or other measured physical parameter applied to the sensor die 236.

Another way to address the situation discussed above regarding stop elements decreasing a width of a gap between a cap and an elastic element below a minimum required to prevent the elastic element from directly contacting the cap within the operating range of measured parameter is to keep the same material used to form the stop elements as layers 220 in the bonding area between the cap and device wafer layers or to add a different material or stack of materials in the bonding area between the cap and device wafer layers. In this way, a width of the gap between the cap and device wafer layers can be equal to a thickness of the bond layer 212 and the kept layers 220. Keeping the layers 220 in the bonding area can be particularly useful in a case of thin bond layers. For example, if cap bonding is done using Au-to-Au thermocompression, then a thickness of the bond layer can be close to 1 $\mu$m. If a minimum gap width of 1.5 $\mu$m is required, then the stop elements 216 can be formed, for example, using 0.7 $\mu$m thick poly-silicon, poly-silicon layers 220 can be kept in the bonding area, and the location of the stop elements 216 can be chosen in such a way that the stop elements 216 make direct contact with the central portion 211 of the cap wafer layer 202 only when the maximum deflection of the elastic element 204 exceeds 1.5 um.

FIG. 44 shows another embodiment of a sensor die 237 configured for low pressure sensing. The die 237 is the same as the die 200 of FIG. 33 except that the bond layer 212 is thicker. The bond layer 212 in this illustrated embodiment has a thickness that is greater than the maximum allowable gap 214 between the central thin area 205 of the elastic element 204 and the central portion 211 of the cap wafer layer 202. In this case, the bonding area 217 can be recessed in the cap wafer layer 202. A depth of a recess 217 in the cap wafer layer 202 can be chosen to bring the gap 214 to the target gap depth. For example, if a thickness of the bonding layer 212 is 5 μm, the maximum allowable depth of the gap 214 corresponding to the maximum allowable mechanical stress in elastic element 204 is 3.5 μm, and the minimum depth of the gap 214 corresponding to the high end of the measurement range is 1.5 μm, then the recess 217 can have a depth of 2.25 μm with 0.5 μm tolerance. This can allow for gap depth in a range of 1.75 to 2.75 μm. Therefore, mechanical contact with the stop element 218 can happen only outside the measurement range and before the maximum mechanical stress in the elastic element 204 reaches the maximum allowable value. Recessing the bonding area can thus be another way to manage gap width between a cap and an elastic element.

FIG. 45 shows another embodiment of a sensor die 238 configured for low pressure sensing. The die 238 is the same as the die 200 of FIG. 33 except that the sensor die 238 includes a plurality of stop elements 219. In this illustrated embodiment, the stop elements 219 are formed on the cap wafer layer 202, e.g., toward a periphery of the cap wafer layer 202 laterally outward from an edge of the central thin area 205 and laterally inward from the bond layer 212. The stop elements 219 in this illustrated embodiment are configured as hard stops that always contact the opposite wafer layer, the device wafer layer 201 in this illustrated embodiment, whether the central thin area 205 is bending or not. Hard stops can help better control the gap 214 between the central thin area 205and the cap wafer layer 202 and/or can help minimize an amount of bonding material that can be squeezed from the bonding area toward the central thin area 205 or completely eliminate such possibility by making a continuous ring-shaped hard stop. Better gap control can be beneficial because thickness control of some types of bonding material across the wafer stack can be difficult because of non-uniformity of the load applied to the wafer stack. For example, some bending or non-parallelism of platens contacting the stack of wafers during bonding can result in non-uniform distribution of the applied force across the wafer surface. If bonding material can flow during bonding, then precise gap control can be challenging, but the hard stops can help allow the gap to be properly formed.

Another aspect of low-pressure sensor die design is taking into account bending of some portions of the thin elastic element adjacent to through holes that can be etched in the elastic element. Maximum bending of such portions can be significantly smaller than a gap between an elastic element and a cap.

Although silicon has been mentioned as a substrate material in various embodiments described herein, other semiconductor materials can be used to fabricate low pressure sensors, such as silicon carbide (e.g., for high-temperature sensors), gallium arsenide and other III-V semiconductor materials, germanium, etc.

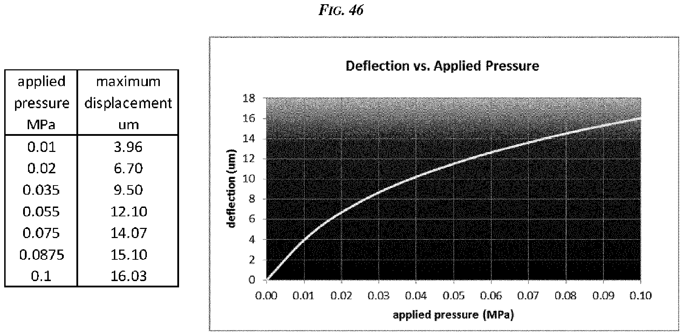

FIG. 46 illustrates a graph showing deflection versus applied pressure for an embodiment of a sensor die configured to sense low pressure and including a cap wafer layer bonded to a device wafer layer with stop elements positioned in a gap therebetween. The graph shows a maximum displacement of a diaphragm of the die under various levels of applied pressure, e.g., if 0.01 MPa is applied to the diaphragm, the diaphragm's maximum displacement is 3.96 um. A person skilled in the art will appreciated that 0.1 MPa of applied pressure corresponds to atmospheric pressure. The graph demonstrates an operating range of the elastic element deflection and where the stop elements can be applied to prevent breakage and/or other damage to the diaphragm during displacement.

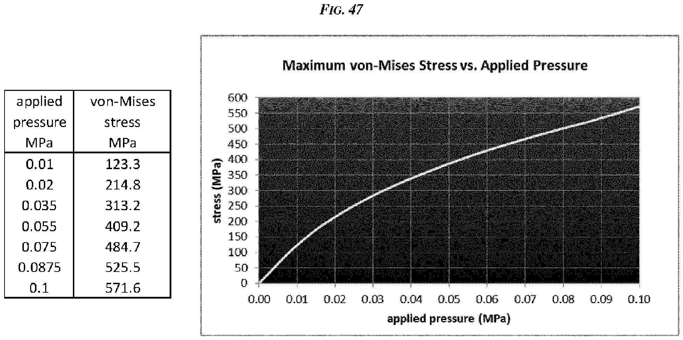

FIG. 47 illustrates a graph showing maximum von-Mises stress versus applied pressure for the sensor die of FIG. 46. The graph shows a maximum von-Mises stress of the die under various levels of applied pressure, e.g., if 0.01 MPa is applied to the diaphragm, then the diaphragm experiences 123.3 MPa stress. If a stop element is positioned in a range of 6 to 8 microns between the cap and the diaphragm, and a maximum stress is in a range of 200 to 300 MPa, the die is safe operationally.

The features disclosed herein with respect to any particular embodiment can be combined with or incorporated into any other embodiment. The graph demonstrates an operating range of the die. For example, 1 GPa is the typical pressure limit for silicon, so 571.6 MPa von-Mises stress at atmospheric pressure is well below that level.

A person skilled in the art will appreciate that measurements discussed herein may not be precisely at a certain value, e.g., be exactly 6 μm or 8 μm, but can be considered to be about that certain value because of, for example, tolerances allowed in manufacturing. A person skilled in the art will also appreciate that low pressure sensors can deviate from the various geometrical structures described herein with neither the functionality of the structures nor performance of the sensor being affected by such deviations. Therefore, the geometrical concepts described herein are used in order to simplify description of the structures.

In one embodiment, the at least one stress concentrator has a shape of a square, a rectangle, a polygon, a square with rounded corners, a rectangle with rounded corners, a polygon with rounded corners, a circle, or an oval.

In one embodiment, the thickness of the at least one rigid island is greater than or equal to 1.5 times the thickness of the thin area of the elastic element.

In one embodiment, the thickness of the thin area is at least 10 times smaller than thickness of the substrate.

In one embodiment, the physical parameter is pressure, force, flow, acceleration, vibration, or vibration frequency.

In one embodiment, the elastic element is a square, a rectangle, a polygon, a square with rounded corners, a rectangle with rounded corners, a polygon with rounded corners, a circle, or an oval.

In one embodiment, the temperature sensor utilizes a p-n junction, a diode, a diffused resistor, a transistor, and/or a thin film thermistor.

In one embodiment, the magnetic sensor utilizes a magnetoresistor, a Hall effect sensor, a component utilizing anisotropic magnetoresistive effect, a component utilizing giant magnetoresistive effect, and/or a component utilizing tunneling magnetoresistive effect.

In the present disclosure, like-named components of the embodiments generally have similar features, and thus within a particular embodiment each feature of each like-named component is not necessarily fully elaborated upon.

This written description uses examples to disclose the invention, including the best mode, and also to enable any person skilled in the art to practice the invention, including making and using any devices or systems and performing any incorporated methods. The patentable scope of the invention is defined by the claims.

**Claims**

1. A device for sensing a physical parameter, comprising:

   a sensor die (70, 80) comprising:

      a substrate (90) made of a semiconductor material, the substrate (90) having a first side, a second side substantially parallel to the first side opposite the first side, and a thickness defined by a distance from the first side to the second side; and
      a cavity formed on the second side of the sensor die (70, 80) creating an elastic element (72, 82) of the sensor die (70, 80) configured to bend in response to the physical parameter exerted on the sensor die (70, 80), the elastic element (72, 82) comprising:

         at least one rigid island (73, 83) formed within the cavity and having a thickness;
         a thin area (77, 87) surrounding the at least one rigid island (73, 83), having a thickness smaller than the rigid island thickness, that acts as a first stress concentrator; and

      a stress-sensitive circuit including at least one stress-sensitive component (76, 86, 88, 89) formed in the thin area (77, 87) of the elastic element (72, 82), the stress-sensitive circuit configured to output a signal proportional to the physical parameter,

**characterized in that**

the elastic element (72, 82) further comprises a second stress concentrator (75, 79, 85) at least partially formed in the thin area (77, 87) of the elastic element (72, 82) on the first side of the substrate (90), wherein the second stress concentrator (75, 79, 85) is configured to increase stress in the locations of the at least one stress-sensitive component (76, 86, 88, 89) resulting in an increase of the device sensitivity to the physical parameter.

2. A device of claim 1, wherein the second stress concentrator (75, 79, 85) comprises a through hole (85) and/or a recess (75, 79).

3. A device of claim 1 or 2, wherein the elastic element (72, 82) has an arrangement comprising:

   the elastic element (72, 82) is square and the at least one rigid island (73, 83) is located in the center of the elastic element (72, 82) surrounded by the thin area (77, 87), and the second stress concentrator (75, 79, 85) is located in a corner of the thin area (77, 87), along an edge of the thin area (77, 87), along an edge of the rigid island (73, 83), perpendicular to an edge of the thin area (77, 87), and/or perpendicular to an edge of rigid island (73, 83);
   the elastic element (72, 82) is rectangular and the at least one rigid island is located in the center of the elastic element (72, 82) surrounded by the thin area (77, 87), and the second stress concentrator (75, 79, 85) is located in a corner of the thin area (77, 87), along an edge of the thin area (77, 87), along an edge of the rigid island (73, 83), perpendicular to an edge of the thin area (77, 87), and/or perpendicular to an edge of rigid island (73, 83);
   the elastic element (72, 82) is square and has a central axis equidistant from two opposite edges of the elastic element (72, 82), the at least one rigid island (73, 83) is two rigid islands (73, 83) located symmetrically with respect to the central axis, and the second stress concentrator (75, 79, 85) is located in a corner of the thin area (77, 87), along an edge of the thin area (77, 87), along an edge of at least one rigid island (73, 83), perpendicular to an edge of the thin area (77, 87), perpendicular to an edge of at least one rigid island (73, 83), and/or parallel to the central axis; or
   the elastic element (72, 82) is rectangular and has a central axis equidistant from two opposite edges of the elastic element (72, 82), the at least one rigid island (73, 83) is two rigid islands (73, 83) located symmetrically with respect to the central axis, the second stress concentrator (75, 79, 85) is located in a corner of the thin area (77, 87), along an edge of the thin area (77, 87), along an edge of at least one rigid island (73, 83), perpendicular to an edge of the thin area (77, 87), perpendicular to an edge of at least one rigid island (73, 83), and/or parallel to the central axis.

4. The device of one of the claims 1 to 3, wherein the sensor die (70, 80) is manufactured on silicon substrate (90) and the cavity and the at least one rigid island (73, 83) have an arrangement comprising:

pyramidal cavity with at least two side walls having (111) crystallographic orientation and one pyramidal rigid island (73, 83) having at least two side walls having (111) crystallographic orientation;

pyramidal cavity with at least two side walls having (111) crystallographic orientation and two pyramidal rigid islands (73, 83) each having at least two side walls having (111) crystallographic orientation;

prism-shaped cavity with side walls making an angle from 85 degrees to 95 degrees with respect to a bottom of the cavity and one prism-shaped rigid island (73, 83) with side walls making an angle from 85 degrees to 95 degrees with respect to the bottom of the cavity;

prism-shaped cavity with side walls making angle from 85 degrees to 95 degrees with respect to a bottom of the cavity and two prism-shaped rigid islands (73, 83) each with side walls making an angle from 85 degrees to 95 degrees with respect to the bottom of the cavity;

pyramidal cavity with at least two side walls having (111) crystallographic orientation and one prism-shaped rigid island (73, 83) with side walls making an angle from 85 degrees to 95 degrees with respect to a bottom of the cavity; or

pyramidal cavity with at least two side walls having (111) crystallographic orientation and two prism-shaped rigid islands (73, 83) with side walls making an angle from 85 degrees to 95 degrees with respect to a bottom of the cavity.

5. The device of one of the claims 1 to 4, wherein the thickness of the elastic element (72, 82) and the at least one rigid island (73, 83) is less than a thickness of the substrate (90).

6. The device of one of the claims 1 to 5, wherein the elastic element (72, 82) is at least partially surrounded by a thin frame (68), wherein a thickness of the thin frame (68) is substantially equal to a thickness of the at least one rigid island (73, 83).

7. The device of one of the claims 1 to 6, wherein a peripheral edge of the elastic element (72, 82) is substantially parallel to an edge of the at least one rigid island (73, 83) and a distance from the peripheral edge of the elastic element (72, 82) and the edge of the at least one rigid island (73, 83) is substantially smaller than a length of the edge of the rigid island (73, 83), forming a narrow groove (74) between at least one rigid island (73, 83) and the edge of the elastic element (72, 82), wherein at least one stress-sensitive component (76, 86, 88, 89) is located in the narrow groove (74).

8. The device of one of the claims 1 to 7, wherein the at least one rigid island (73, 83) comprises a first rigid island (73, 83) having a first edge and a second rigid island (73, 83) having a second edge substantially parallel to the first edge, wherein a distance between the first edge and the second edge is substantially smaller than a length of the first edge and the second edge, forming a narrow groove (74), wherein the at least one stress-sensitive component (76, 86, 88, 89) is located in said narrow groove (74) between the two rigid islands (73, 83).

9. The device of one of the claims 1 to 8, further comprising a cap bonded to the first side of the substrate (90), a bonding area between the cap and the substrate (90) that does not overlap with the elastic element (72, 82), a gap between the elastic element (72, 82) and a surface of the cap that faces the elastic element (72, 82), and at least one stop area on the cap facing the elastic element (72, 82), wherein the device is configured such that:

in response to the measured parameter that is less than a threshold, the elastic element (72, 82) deflects without making contact with the at least one stop area;
in response to the measured parameter that is greater than the threshold, the elastic element (72, 82) deflects and makes contact with the at least one stop area and the cap provides additional support to increase a maximum value of the physical parameter the elastic element (72, 82) can withstand without damage.

10. The device of claim 9, wherein a surface area of the at least one stop area that makes contact with the elastic element (72, 82) is such that a sticking force formed between the at least one stop area and the elastic element (72, 82) when the at least one stop area makes contact with the elastic element (72, 82) is less than a restoring force generated in the elastic element (72, 82) due to its deformation by the physical parameter.

**11.** The device of claim 9 or 10, wherein the cap has at least one through hole (209) above the elastic element (72, 82).

**12.** The device of one of the claims 1 to 11, wherein the at least one stress-sensitive component (76, 86, 88, 89) comprises a first group of stress-sensitive components (76, 86, 88, 89) used to measure a slow changing physical parameter and a second group of stress-sensitive components (76, 86, 88, 89) used to measure a fast changing physical parameter, wherein the slow changing physical parameter is pressure or flow and the fast changing physical parameter is linear acceleration, angular acceleration, or angular velocity.

**13.** The device of one of the claims 1 to 12, wherein the at least one stress-sensitive component (76, 86, 88, 89) comprises a resistor, a diode, a p-n-p bipolar transistor, an n-p-n bipolar transistor, a p-channel MOS transistor, an n-channel MOS transistor, a CMOS transistor pair, a piezoresistor connected to a bipolar transistor, and/or a piezoresistor connected to a MOS transistor.

**14.** The device of one of the claims 1 to 13, wherein the stress-sensitive circuit provides an analog differential output signal proportional to the measured parameter, an analog output signal measured with respect to a reference potential and proportional to the measured parameter, analog amplification, analog-to-digital conversion, analog-to-frequency conversion, pulse generation, analog multiplexing, signal processing, memory, a digital interface, power management, transmitting and/or receiving radio-signals, and/or energy harvesting.

**15.** The device of one of the claims 1 to 14, further comprising a temperature sensor fabricated together with the stress-sensitive circuit.

**16.** The device of one of the claims 1 to 15, further comprising a magnetic sensor fabricated together with the stress-sensitive integrated circuit.

**Patentansprüche**

**1.** Vorrichtung zum Erfassen eines physikalischen Parameters, umfassend:

einen Sensorchip (70, 80), umfassend:

ein Substrat (90) aus einem Halbleitermaterial, wobei das Substrat (90) eine erste Seite, eine zweite Seite im Wesentlichen parallel zur und gegenüber der ersten Seite und eine durch einen Abstand von der ersten Seite zur zweiten Seite definierte Dicke aufweist; und

einen Hohlraum, der auf der zweiten Seite des Sensorchips (70, 80) ausgebildet ist und ein elastisches Element (72, 82) des Sensorchips (70, 80) erzeugt, das derart konfiguriert ist, um sich als Reaktion auf den auf den Sensorchip (70, 80) ausgeübten physikalischen Parameter zu biegen, wobei das elastische Element (72, 82) umfasst:

mindestens eine innerhalb des Hohlraums ausgebildete starre Insel (73, 83), und die eine Dicke aufweist; einen dünnen Bereich (77, 98), welche die mindestens eine starre Insel (73, 83) umgibt und eine Dicke aufweist, welche kleiner ist als die Dicke der starren Insel, und die als erster Belastungskonzentrator fungiert; und eine spannungsempfindliche Schaltung, die mindestens eine spannungsempfindliche Komponente (76, 86, 88, 89) umfasst, die im dünnen Bereich (77, 87) des elastischen Elements (72, 82) gebildet ist, wobei die spannungsempfindliche Schaltung dazu konfiguriert ist, ein Signal proportional zum physikalischen Parameter auszugeben,

**dadurch gekennzeichnet, dass**
das elastische Element (72, 82) zudem einen zweiten Belastungskonzentrator (75, 85) umfasst, der zumindest teilweise im dünnen Bereich (77, 87) des elastischen Elements (72, 82) auf der ersten Seite des Substrats (90) ausgebildet ist, worin der zweite Belastungskonzentrator (75, 79, 85) konfiguriert ist, um die Spannung an den Orten der mindestens einen spannungsempfindlichen Komponente (76, 86, 88, 89) zu erhöhen, was zu einer Erhöhung der Empfindlichkeit der Vorrichtung gegenüber dem physikalischen Parameter führt.

**2.** Vorrichtung gemäss Anspruch 1, worin der zweite Belastungskonzentrator (75, 79, 85) ein Durchgangsloch (85) und/oder eine Vertiefung (75, 79) umfasst.

**3.** Vorrichtung gemäss Anspruch 1 oder 2, worin das elastische Element (72, 82) eine Anordnung aufweist, umfassend:

das elastische Element (72, 82) ist quadratisch und die mindestens eine starre Insel (73, 83) ist in der Mitte des elastischen Elements (72, 82) angeordnet und vom dünnen Bereich (77, 87) umgeben, und der zweite Belastungskonzentrator (75, 79, 85) befindet sich in einer Ecke des dünnen Bereichs (77, 87), entlang einer Kante des dünnen Bereichs (77, 87), entlang einer Kante der starren Insel (73, 83), senkrecht zu einer Kante des dünnen Bereichs (77, 87) und/oder senkrecht zu einer Kante der starren Insel (73, 83);

das elastische Element (72, 82) ist rechteckig und die mindestens eine starre Insel befindet sich in der Mitte des elastischen Elements (72, 82) und vom dünnen Bereich (77, 87) umgeben, und der zweite Belastungskonzentrator (75, 79, 85) befindet sich in einer Ecke des dünnen Bereichs (77, 87), entlang einer Kante des dünnen Bereichs (77, 87), entlang einer Kante der starren Insel (73, 83), senkrecht zu einer Kante des dünnen Bereichs (77, 87) und/oder senkrecht zu einer Kante der starren Insel (73, 83);

das elastische Element (72, 82) ist quadratisch und hat eine Mittelachse, die äquidistant von zwei gegenüberliegenden Kanten des elastischen Elements (72, 82) liegt, die mindestens eine starre Insel (73, 83) ist zwei starre Inseln (73, 83), die symmetrisch in Bezug auf die Mittelachse angeordnet sind, und der zweite Belastungskonzentrator (75, 79, 85) befindet sich in einer Ecke des dünnen Bereichs (77, 87), entlang einer Kante des dünnen Bereichs (77, 87), entlang einer Kante von mindestens einer starren Insel (73, 83), senkrecht zu einer Kante des dünnen Bereichs (77, 87), senkrecht zu einer Kante von mindestens einer starren Insel (73, 83) und/oder parallel zur Mittelachse, oder

das elastische Element (72, 82) ist rechteckig und hat eine Mittelachse, die äquidistant von zwei gegenüberliegenden Kanten des elastischen Elements (72, 82) liegt, die mindestens eine starre Insel (73, 83) ist zwei starre Inseln (73, 83), die symmetrisch in Bezug auf die Mittelachse angeordnet sind, und der zweite Belastungskonzentrator (75, 79, 85) befindet sich in einer Ecke des dünnen Bereichs (77, 87), entlang einer Kante des dünnen Bereichs (77, 87), entlang einer Kante von mindestens einer starren Insel (73, 83), senkrecht zu einer Kante des dünnen Bereichs (77, 87), senkrecht zu einer Kante von mindestens einer starren Insel (73, 83) und/oder parallel zur Mittelachse.

4. Vorrichtung gemäss einem der Ansprüche 1 bis 3, worin der Sensorchip (70, 80) auf einem Siliziumsubstrat (90) hergestellt wird und der Hohlraum und die mindestens eine starre Insel (73, 83) eine Anordnung aufweisen, umfassend: Pyramidenhohlraum mit mindestens zwei Seitenwänden, die (111) kristallographische Ausrichtung aufweisen und eine pyramidenförmige starre Insel (73, 83) mit mindestens zwei Seitenwänden mit (111) kristallographischer Orientierung;

Pyramidenhohlraum mit mindestens zwei Seitenwänden mit (111) kristallographischer Ausrichtung und zwei pyramidenförmigen starren Inseln (73, 83), die jeweils mindestens zwei Seitenwände mit (111) kristallographischer Orientierung aufweisen;

prismenförmigen Hohlraum mit Seitenwänden, die einen Winkel von 85 Grad bis 95 Grad in Bezug auf einen Boden des Hohlraums bilden, und eine prismenförmige starre Insel (73, 83) mit Seitenwänden, die einen Winkel von 85 Grad bis 95 Grad in Bezug auf den Boden des Hohlraums bilden;

prismenförmigen Hohlraum mit Seitenwänden, die einen Winkel von 85 Grad bis 95 Grad in Bezug auf einen Boden des Hohlraums bilden, und zwei prismenförmige starre Inseln (73, 83) jeweils mit Seitenwänden, die einen Winkel von 85 Grad bis 95 Grad in Bezug auf den Boden des Hohlraums bilden;

pyramidenförmigen Hohlraum mit mindestens zwei Seitenwänden mit (111) kristallographischer Ausrichtung und einer prismenförmigen starren Insel (73, 83) mit Seitenwänden, die einen Winkel von 85 Grad bis 95 Grad in Bezug auf einen Boden des Hohlraums bilden; oder

pyramidenförmigen Hohlraum mit mindestens zwei Seitenwänden mit (111) kristallographischer Ausrichtung und zwei prismenförmigen starren Inseln (73, 83) mit Seitenwänden, die einen Winkel von 85 Grad bis 95 Grad in Bezug auf einen Boden des Hohlraums bilden.

5. Vorrichtung gemäss einem der Ansprüche 1 bis 4, worin die Dicke des elastischen Elements (72, 82) und der mindestens einen starren Insel (73, 83) geringer als eine Dicke des Substrats (90) ist.

6. Vorrichtung gemäss einem der Ansprüche 1 bis 5, worin das elastische Element (72, 82) zumindest teilweise von einem dünnen Rahmen (68) umgeben ist, worin eine Dicke des dünnen Rahmens (68) im Wesentlichen gleich einer Dicke der mindestens einen starren Insel (73, 83) ist.

7. Vorrichtung gemäss einem der Ansprüche 1 bis 6, worin eine Umfangskante des elastischen Elements (72, 82) im Wesentlichen parallel zu einer Kante der mindestens einen starren Insel (73, 83) ist und ein Abstand von der Umfangskante des elastischen Elements (72, 82) und der Kante der mindestens einen starren Insel (73, 83) wesentlich kleiner ist als eine Länge der Kante der starren Insel (73, 83), die eine schmale Rille (74) zwischen mindestens einer starren Insel (73, 83) und der Kante des elastischen Elements (72, 82) bildet, worin sich mindestens eine belastungsempfindliche Komponente (76, 86, 88, 89) in der schmalen Rille (74) befindet.

8. Vorrichtung gemäss einem der Ansprüche 1 bis 7, worin die mindestens eine starre Insel (73, 83) eine erste starre Insel (73, 83) mit einer ersten Kante und eine zweite starre Insel (73, 83) mit einer zweiten Kante im Wesentlichen parallel zur ersten Kante umfasst, worin ein Abstand zwischen der ersten Kante und der zweiten Kante wesentlich kleiner ist als eine Länge der ersten Kante und der zweiten Kante und eine schmale Rille (74) bildet, worin sich die mindestens eine belastungsempfindliche Komponente (76, 86, 88, 89) in der besagten schmalen Rille (74) zwischen den beiden starren Inseln (73, 83) befindet.

9. Vorrichtung gemäss einem der Ansprüche 1 bis 8, zudem umfassend eine mit der ersten Seite des Substrats (90) verbundene Kappe, eine Verbundfläche zwischen der Kappe und dem Substrat (90), die nicht mit dem elastischen Element (72, 82) überlappt, eine Lücke zwischen dem elastischen Element (72, 82) und einer dem elastischen Element (72, 82) zugewandten Oberfläche der Kappe, und mindestens einen dem elastischen Element (72, 82) zugewandten Anschlagbereich, worin die Vorrichtung derart konfiguriert ist, dass

   als Reaktion auf den gemessenen Parameter, der kleiner als ein Schwellenwert ist, das elastische Element (72, 82) sich beugt, ohne mit dem mindestens einen Anschlagbereich in Kontakt zu treten;
   als Reaktion auf den gemessenen Parameter, der grösser als der Schwellenwert ist, das elastische Element (72, 82) den mindestens einen Anschlagbereich sich beugt und mit dem mindestens einen Anschlagbereich in Kontakt tritt, und die Kappe zusätzliche Unterstützung bietet, um einen maximalen Wert des physikalischen Parameters zu erhöhen, dem das elastische Element (72, 82) ohne Schaden widerstehen kann.

10. Vorrichtung gemäss Anspruch 9, worin ein Oberflächenbereich des mindestens einen Anschlagsbereichs, der in Kontakt mit dem elastischen Element (72, 82) tritt, derart ist, dass, wenn der mindestens eine Anschlagsbereich in Kontakt mit dem elastischen Element (72, 82) tritt, eine zwischen dem mindestens einen Anschlagsbereich und dem elastischen Element (72, 82) gebildete Haftkraft geringer als eine Rückstellkraft ist, die im elastischen Element (72, 82) aufgrund seiner Verformung durch den physikalischen Parameter erzeugt wird.

11. Vorrichtung gemäss Anspruch 9 oder 10, worin die Kappe mindestens ein Durchgangsloch (209) über dem elastischen Element (72, 82) aufweist.

12. Vorrichtung gemäss einem der Ansprüche 1 bis 11, worin die mindestens eine spannungsempfindliche Komponente (76, 86, 88, 89) umfasst: eine erste Gruppe spannungsempfindlicher Komponenten (76, 86, 88, 89), die verwendet werden, um einen sich langsam ändernden physikalischen Parameter zu messen, und eine zweite Gruppe spannungsempfindlicher Komponenten (76, 86, 88, 89), die verwendet werden, um sich schnell ändernde physikalische Parameter zu messen, worin der sich langsam ändernde physikalische Parameter Druck oder Fluss ist und der sich schnell ändernde physikalische Parameter lineare Beschleunigung, Winkelbeschleunigung oder Winkelgeschwindigkeit ist.

13. Vorrichtung gemäss einem der Ansprüche 1 bis 12, worin die mindestens eine spannungsempfindliche Komponente (76, 86, 88, 89) umfasst: einen Widerstand, eine Diode, einen pnp-Bipolartransistor, einen npn-Bipolartransistor, einen p-Kanal-MOS-Transistor, einen n-Kanal-MOS-Transistor, ein CMOS-Transistorpaar, ein Piezowiderstand, der mit einem Bipolartransistor verbunden ist, und/oder ein Piezowiderstand, der mit einem MOS-Transistor verbunden ist.

14. Vorrichtung gemäss einem der Ansprüche 1 bis 13, worin die spannungsempfindliche Schaltung liefert: ein analoges Differenzausgangssignal, das proportional zum gemessenen Parameter ist, ein analoges Ausgangssignal, das in Bezug auf ein Bezugspotential gemessen wird und proportional zum gemessenen Parameter ist, analoge Verstärkung, Analog-Digital-Wandlung, Analog-zu-Frequenz-Wandlung, Impulserzeugung, Analog-Multiplexing, Signalverarbeitung, Speicher, eine digitale Schnittstelle, Energiemanagement, Senden und/oder Empfangen von Funksignalen und/oder Energiegewinnung.

15. Vorrichtung gemäss einem der Ansprüche 1 bis 14, zudem umfassend einen Temperatursensor, der zusammen mit der belastungsempfindlichen Schaltung hergestellt wird.

16. Vorrichtung gemäss einem der Ansprüche 1 bis 15, zudem umfassend einen Magnetsensor, der zusammen mit der belastungsempfindlichen integrierten Schaltung hergestellt wird.

**Revendications**

1. Dispositif pour détecter un paramètre physique, comprenant:

   une puce de capteur (70, 80) comprenant:

   un substrat (90) constitué d'un matériau semi-conducteur, le substrat (90) ayant un premier côté, un second côté substantiellement parallèle au premier côté opposé au premier côté, et une épaisseur définie par une distance du premier côté au deuxième côté; et

une cavité formée sur le second côté de la puce de capteur (70, 80) créant un élément élastique (72, 82) de la puce de capteur (70, 80) configuré pour se plier en réponse au paramètre physique exercé sur la puce de capteur (70, 80), l'élément élastique (72, 82) comprenant:

au moins un îlot rigide (73, 83) formé dans la cavité et ayant une épaisseur; une zone mince (77, 87) entourant le au moins un îlot rigide (73, 83) et ayant une épaisseur inférieure à l'épaisseur de l'îlot rigide, agissant comme premier concentrateur de contraintes ; et

un circuit sensible à la contrainte comprenant au moins un composant sensible à la contrainte (76, 86, 88, 89) formé dans la zone mince (77, 87) de l'élément élastique (72, 82), le circuit sensible à la contrainte étant configuré pour délivrer un signal proportionnel au paramètre physique,

**caractérisé en ce que**

l'élément élastique (72, 82) comprend en outre un deuxième concentrateur de contrainte (75, 79, 85) au moins partiellement formé dans la zone mince (77, 87) de l'élément élastique (72, 82) sur un premier côté du substrat (90), dans lequel le deuxième concentrateur de contrainte (75, 79, 85) est configuré pour augmenter la contrainte dans les emplacements du au moins un composant sensible à la contrainte (76, 86, 88, 89), ce qui entraîne une augmentation de la sensibilité du dispositif au paramètre physique.

2. Dispositif selon la revendication 1, dans lequel le deuxième concentrateur de contrainte (75, 79, 85) comprend un trou traversant (85) et/ou un évidement (75, 79).

3. Dispositif selon la revendication 1 ou 2, dans lequel l'élément élastique (72, 82) a un agencement comprenant:

l'élément élastique (72, 82) est carré et le au moins un îlot rigide (73, 83) est situé au centre de l'élément élastique (72, 82) entouré par la zone mince (77, 87), et le deuxième concentrateur de contrainte (75, 79, 85) est situé dans un coin de la zone mince (77, 87), le long d'un bord de la zone mince (77, 87), le long d'un bord de l'îlot rigide (73, 83) et/ou perpendiculaire à un bord de l'îlot rigide (73, 83);

l'élément élastique (72, 82) est rectangulaire et le au moins un îlot rigide est situé au centre de l'élément élastique (72, 82) entouré par la zone mince (77, 87), et le deuxième concentrateur de contrainte (75, 79, 85) est situé dans un coin de la zone mince (77, 87), le long d'un bord de la zone mince (77, 87), le long d'un bord de l'îlot rigide (73, 83), perpendiculaire à un bord de la zone mince (77, 87) et/ou perpendiculaire à un bord de l'îlot rigide (73, 83);

l'élément élastique (72, 82) est carré et présente un axe central équidistant de deux bords opposés de l'élément élastique (72, 82), le au moins un îlot rigide (73, 83) est deux îlots rigides (73, 83) situés symétriquement par rapport à l'axe central et le deuxième concentrateur de contraintes (75, 79, 85) est situé dans un coin de la zone mince (77, 87), le long d'un bord de la zone mince (77, 87), le long d'un bord d'au moins un îlot rigide (73, 83), perpendiculaire à un bord de la zone mince (77, 87), perpendiculaire à un bord d'au moins un îlot rigide (73, 83) et/ou parallèle à l'axe central; ou

l'élément élastique (72, 82) est rectangulaire et présente un axe central équidistant de deux bords opposés de l'élément élastique (72, 82), le au moins un îlot rigide (73, 83) est deux îlots rigides (73, 83) situés symétriquement par rapport à l'axe central, le deuxième concentrateur de contraintes (75, 79, 85) est situé dans un coin de la zone mince (77, 87), le long d'un bord de la zone mince (77, 87), le long d'un bord d'au moins un îlot rigide (73, 83), perpendiculaire à un bord de la zone mince (77, 87), perpendiculaire à un bord d'au moins un îlot rigide (73, 83) et/ou parallèle à l'axe central.

4. Dispositif selon l'une des revendications 1 à 3, dans lequel la puce de capteur (70, 80) est fabriquée sur un substrat de silicium (90) et la cavité et le au moins un îlot rigide (73, 83) ont un agencement comprenant:

une cavité pyramidale avec au moins deux parois latérales ayant (111) une orientation cristallographique et un îlot rigide pyramidal (73, 83) ayant au moins deux parois latérales ayant (111) une orientation cristallographique ;
une cavité pyramidale avec au moins deux parois latérales ayant (111) une orientation cristallographique et deux îlots rigides pyramidaux (73, 83) ayant chacune au moins deux parois latérales ayant (111) une orientation cristallographique;
une cavité en forme de prisme avec des parois latérales formant un angle de 85 degrés à 95 degrés par rapport au fond de la cavité et un îlot rigide en forme de prisme (73, 83) avec des parois latérales formant un angle de 85 degrés à 95 degrés par rapport au fond de la cavité;

une cavité en forme de prisme avec des parois latérales formant un angle de 85 degrés à 95 degrés par rapport au fond de la cavité et deux îlots rigides en forme de prisme (73, 83), chacun avec des parois latérales formant un angle de 85 degrés à 95 degrés par rapport au fond de la cavité;

une cavité pyramidale avec au moins deux parois latérales ayant (111) une orientation cristallographique et un îlot rigide en forme de prisme (73, 83) avec des parois latérales formant un angle de 85 degrés à 95 degrés par rapport à un fond de la cavité; ou

une cavité pyramidale avec au moins deux parois latérales ayant (111) une orientation cristallographique et deux îlots rigides en forme de prisme (73, 83) avec des parois latérales formant un angle de 85 degrés à 95 degrés par rapport à un fond de la cavité.

5. Dispositif selon l'une des revendications 1 à 4, dans lequel l'épaisseur de l'élément élastique (72, 82) et dudit au moins un îlot rigide (73, 83) est inférieure à l'épaisseur du substrat (90).

6. Dispositif selon l'une des revendications 1 à 5, dans lequel l'élément élastique (72, 82) est au moins partiellement entouré par un cadre mince (68), une épaisseur du cadre mince (68) étant sensiblement égale à l'épaisseur dudit au moins un îlot rigide (73, 83).

7. Dispositif selon l'une des revendications 1 à 6, dans lequel un bord périphérique de l'élément élastique (72, 82) est substantiellement parallèle à un bord dudit au moins un îlot rigide (73, 83) et une distance du bord périphérique de l'élément élastique (72, 82) et du bord dudit au moins un îlot rigide (73, 83) est substantiellement plus petite qu'une longueur du bord de l'îlot rigide (73 83), formant une rainure étroite (74) entre au moins un îlot rigide (73, 83) et le bord de l'élément élastique (72, 82), au moins un composant sensible à la contrainte (76, 86, 88, 89) étant situé dans la rainure étroite (74).

8. Dispositif selon l'une des revendications 1 à 7, dans lequel le au moins un îlot rigide (73, 83) comprend un premier îlot rigide (73, 83) présentant un premier bord et un deuxième îlot rigide (73, 83) présentant un deuxième bord substantiellement parallèle au premier bord, dans lequel une distance entre le premier bord et le deuxième bord est substantiellement plus petite qu'une longueur du premier bord et du deuxième bord, formant une rainure étroite (74), dans lequel le au moins un composant sensible à la contrainte (76, 86, 88, 89) est situé dans ladite rainure étroite (74) entre les deux îlots rigides (73, 83).

9. Dispositif selon l'une des revendications 1 à 8, comprenant en outre un capuchon lié au premier côté du substrat (90), une zone de liaison entre le capuchon et le substrat (90) qui ne chevauche pas l'élément élastique (72, 82), un espace entre l'élément élastique (72, 82) et une surface du capuchon qui fait face à l'élément élastique (72, 82), et au moins une zone d'arrêt sur le capuchon faisant face à l'élément élastique (72, 82), le dispositif étant configuré de telle sorte que:

en réponse au paramètre mesuré qui est inférieur à un seuil, l'élément élastique (72, 82) se défléchit sans établir un contact avec la au moins une zone d'arrêt;

en réponse au paramètre mesuré qui est supérieur au seuil, l'élément élastique (72, 82) se défléchit et entre en contact avec la au moins une zone d'arrêt et le capuchon fournit un support supplémentaire pour augmenter la valeur maximale du paramètre physique que l'élément élastique (72, 82) peut supporter sans être endommagé.

10. Dispositif selon la revendication 9, dans lequel une surface de la au moins une zone d'arrêt qui entre en contact avec l'élément élastique (72, 82) est telle qu'une force d'adhérence formée entre la au moins une zone d'arrêt et l'élément élastique (72, 82) lorsque la au moins une zone d'arrêt entre en contact avec l'élément élastique (72, 82) est inférieure à une force de rappel générée dans l'élément élastique (72, 82) en raison de sa déformation par le paramètre physique.

11. Dispositif selon la revendication 9 ou 10, dans lequel le capuchon comporte au moins un trou traversant (209) au-dessus de l'élément élastique (72, 82).

12. Dispositif selon l'une des revendications 1 à 11, dans lequel le au moins un composant sensible à la contrainte (76, 86, 88, 89) comprend un premier groupe de composants sensibles à la contrainte (76, 86, 88, 89) utilisés pour mesurer un paramètre physique à changement lent, et un deuxième groupe de composants sensibles à la contrainte (76, 86, 88, 89) utilisés pour mesurer un paramètre physique à changement rapide, dans lequel le paramètre physique à changement lent est la pression ou le débit et le paramètre physique à changement rapide est l'accélération linéaire, l'accélération angulaire ou la vitesse angulaire.

13. Dispositif selon l'une des revendications 1 à 12, dans lequel ledit au moins un composant sensible à la contrainte (76, 86, 88, 89) comprend une résistance, une diode, un transistor bipolaire PNP, un transistor bipolaire NPN, un transistor MOS à canal P, un transistor MOS à canal N, une paire de transistors CMOS, une piézorésistance connectée à un transistor bipolaire et/ou une piézorésistance connectée à un transistor MOS.

14. Dispositif selon l'une des revendications 1 à 13, dans lequel le circuit sensible à la contrainte fournit un signal de sortie différentiel analogique proportionnel au paramètre mesuré, un signal de sortie analogique mesuré par rapport à un potentiel de référence et proportionnel au paramètre mesuré, une amplification analogique, une conversion analogique-numérique, une conversion analogique-fréquence, une génération d'impulsions, un multiplexage analogique, un traitement du signal, une mémoire, une interface numérique, une gestion de l'énergie, une transmission et/ou réception de signaux radio, et/ou une récupération d'énergie.

15. Dispositif selon l'une des revendications 1 à 14, comprenant en outre un capteur de température fabriqué avec le circuit sensible à la contrainte.

16. Dispositif selon l'une des revendications 1 à 15, comprenant en outre un capteur magnétique fabriqué avec le circuit intégré sensible aux contraintes (76, 86, 88, 89).

*FIG. 1*

*FIG. 2*

*FIG. 3*

*FIG. 4*

*FIG. 5*

*FIG. 6*

*FIG. 7*

*FIG. 8*

*FIG. 9*

*FIG. 10*

*FIG. 11*

*FIG. 12*

*FIG. 13*

*FIG. 14*

## FIG. 15

58

57 57 57

59

## FIG. 16

60

## FIG. 17

56

51    62    54    63    55    64    51

61

## FIG. 18

52

51

53

## FIG. 19

54    55

## FIG. 20

56

54    55

*Fig. 21*

*Fig. 22*

*Fig. 23*

*Fig. 24*

*Fig. 25*

FIG. 26

FIG. 27

FIG. 28

FIG. 29

*FIG. 30*

96 96

*FIG. 31*

97 99 98 99 97

*FIG. 32*

100 100

*FIG. 33*

202
213
212
201
208 209 209 212
210 211 210 208 200
207 206 205 206 207 235
203 214 203
204

*FIG. 34*

230

*FIG. 35*

232
222 221 222
233

*FIG. 36*

*FIG. 37*

*FIG. 38*

*FIG. 39*

*FIG. 40*

*FIG. 41*

FIG. 42

202

234

212

211

212

201

215   205   214

FIG. 43

202

236

212

211

212

201

220   216   205   214   216   220

FIG. 44

217

202

217

237

212

211

212

201

217 218   205   214

FIG. 45

217

202

217

238

212

211

212

201

219   205   214   219

FIG. 46

| applied pressure MPa | maximum displacement um |
|---|---|
| 0.01 | 3.96 |
| 0.02 | 6.70 |
| 0.035 | 9.50 |
| 0.055 | 12.10 |
| 0.075 | 14.07 |
| 0.0875 | 15.10 |
| 0.1 | 16.03 |

**Deflection vs. Applied Pressure**

*FIG. 47*

| applied pressure MPa | von-Mises stress MPa |
|---|---|
| 0.01 | 123.3 |
| 0.02 | 214.8 |
| 0.035 | 313.2 |
| 0.055 | 409.2 |
| 0.075 | 484.7 |
| 0.0875 | 525.5 |
| 0.1 | 571.6 |

Maximum von-Mises Stress vs. Applied Pressure

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2011298705 A
- US 2006272413 A
- US 2011048138 A